# EUROPÄISCHE PATENTSCHRIFT

(11) **EP 2 945 820 B1**
(45) Veröffentlichungstag und Bekanntmachung des Hinweises auf die Patenterteilung: **31.07.2019**
(21) Anmeldenummer: 14700700.9
(22) Anmeldetag: 16.01.2014
(51) Int. Cl.: B60R 11/00, H02J 7/02, F16M 11/04, F16B 2/02, F16M 13/00, F16M 13/02

(54) **HALTEVORRICHTUNG FÜR EIN DRAHTLOS KOPPELBARES ENDGERÄT UND VERFAHREN ZUR HERSTELLUNG EINER HALTEVORRICHTUNG**
RETAINING DEVICE FOR A TERMINAL WHICH CAN BE COUPLED IN A WIRELESS MANNER, AND METHOD FOR PRODUCING A RETAINING DEVICE
DISPOSITIF DE MAINTIEN POUR TERMINAL POUVANT ÊTRE COUPLÉ SANS FIL, ET PROCÉDÉ DE RÉALISATION D'UN DISPOSITIF DE MAINTIEN

(30) Priorität: 18.01.2013 DE 102013200811
(43) Veröffentlichungstag der Anmeldung: 25.11.2015
(73) Patentinhaber: Novero Dabendorf GmbH, 15806 Dadendorf (DE)
(72) Erfinder: SCHOLZ, Frank, 13505 Berlin (DE); HOLZ, Rainer, 12107 Berlin (DE)
(74) Vertreter: Ramrath, Lukas
(86) Internationale Anmeldenummer: PCT/EP2014/050826
(87) Internationale Veröffentlichungsnummer: WO 2014/111478

(56) Entgegenhaltungen:
- WO-A1-2009/012033
- DE-A1- 10 123 556
- DE-U1-202011 052 313
- FR-A1- 2 946 830
- US-A- 4 915 273
- US-A1- 2007 101 372
- US-A1- 2009 270 727
- US-A1- 2010 007 805
- US-A1- 2012 091 948

## Beschreibung

Die Erfindung betrifft eine Haltevorrichtung für ein drahtlos koppelbares Endgerät sowie ein Verfahren zur Herstellung einer solchen Haltevorrichtung.

Endgeräte, insbesondere portable elektrische oder elektronische Endgeräte, z.B. Mobiltelefone, PDAs (Personal Digital Assistant), Audio- und Video-Wiedergabegeräte, Fotoapparate, am Kopf tragbare Lautsprecher und Mikrofoneinheiten (so genannte Headsets), Taschenlampen, Zahnbürsten und Kaffeetassen mit integrierter Heizung, um nur einige zu nennen, besitzen einen Energiespeicher zur Versorgung des elektrischen Geräts mit elektrischer Energie. Andernfalls könnte das Endgerät nicht oder nur unter permanenter Zufuhr von elektrischer Energie von außen betrieben werden. Zum Laden des Energiespeichers oder zum Betreiben des Endgeräts wird traditionell eine Kabelverbindung zu dem elektrischen Endgerät hergestellt.

Es sind jedoch auch Verfahren zur kabellosen oder drahtlosen Übertragung von elektrischer Energie zum Endgerät bekannt. So kann z.B. eine induktive Übertragung von elektrischer Energie zum Endgerät erfolgen, wodurch der Energiespeicher des Endgeräts aufgeladen werden kann und/oder das Endgerät betrieben werden kann. Hierbei wird von einer primärseitigen Leiterstruktur, insbesondere einer primärseitigen Spulenanordnung, ein elektromagnetisches Wechselfeld erzeugt, welches von einer sekundären, endgeräteseitigen Leiterstruktur empfangen wird, wobei die sekundäre Leiterstruktur einen sekundärseitigen Wechselstrom erzeugt.

Weiter bekannt ist eine kabellose oder drahtlose Kommunikation eines Endgeräts mit weiteren Geräten, z.B. über eine Funkverbindung.

In einigen Anwendungsfällen ist es wünschenswert, dass sich das Endgerät in einer vorbestimmten Position befindet, um eine optimale drahtlose Übertragung von elektrischer Energie und/oder eine drahtlose Übertragung von Daten zu ermöglichen. So ist es z.B. wünschenswert, dass sich das Endgerät beim induktiven Laden in einer vorbestimmten Position und/oder mit einer vorbestimmten Ausrichtung relativ zu einer primärseitigen Leiterstruktur befindet, wodurch eine optimale induktive Übertragung von elektrischer Energie ermöglicht wird.

Auch in Kraftfahrzeugen besteht der Bedarf, Endgeräte, insbesondere portable Endgeräte, induktiv zu laden und/oder eine drahtlose Kommunikation des Endgeräts z.B. mit einem Kommunikationssystem des Fahrzeugs zu ermöglichen. Insbesondere im Fahrbetrieb kann jedoch ein nicht fixiertes Gerät verrutschen, wodurch die Qualität einer induktiven Energieübertragung verringert wird und/oder eine drahtlose Kommunikation gestört werden kann.

Die US 2005/0007067 A1 offenbart eine Vorrichtung zur Leistungsversorgung einer Batterie in einem portablen Gerät, wobei die Vorrichtung einen Primärteil zur Versorgung der Batterie mit Leistung und Mittel zum Leistungsempfang umfasst, wobei die Mittel zum Leistungsempfang mit der Batterie gekoppelt sind. Die Mittel zum Leistungsempfang sind fähig, Leistung vom Primärteil unabhängig von einer Orientierung der Mittel zum Leistungsempfang zu empfangen. Die Druckschrift beschreibt weiter eine Halterung für portable Geräte. Diese Halterung ist als Tasche ausgebildet, wobei portable Endgeräte durch Klebebänder oder Clips gehaltert werden können.

Die US 2012/091948 A1 offenbart ein drahtloses Stromversorgungs- oder Ladesystem, welches eine Spule zum drahtlosen Laden bereitstellt, die am oder in der Konsole in einem Fahrzeuginnenraum montiert. Elektronischen Vorrichtungen, die in oder in der Nähe der Konsole angeordnet sind, werden durch die Spule betrieben und/oder geladen. Die Spule kann in einer Tür mit einer Tasche zur Aufnahme der elektronischen Vorrichtung angeordnet sein.

Die FR 2 946 830 A1 offenbart einen Träger zur Unterstützung einer mobilen elektronischen Vorrichtung, dessen Basis in einem Führerstand eines Fahrzeugs installiert ist. Die Basis integriert eine Übertragungseinrichtung zur induktiven Kopplung mit einer Empfangseinrichtung, die in einen Adapter integriert ist, der mit der Vorrichtung verbunden ist, um die Stromversorgung der Vorrichtung sicherzustellen.

Die DE 101 23 556 A1 offenbart einen Halter zur leicht lösbaren Befestigung eines Handys in einem Kraftfahrzeug mit einer Kombination folgender Merkmale:
- ein erstes Gehäuseteil mit Klemmbacken, von denen wenigstens eine seitlich gegen Federkraft ausziehbar ist und zwischen denen Handys mitunterschiedlichen äußeren Maßen einspannbar sind,
- ein zweites Gehäuseteil, welches seitlich einstellbar mit dem ersten Gehäuseteil verbunden oder zu verbinden ist und eine Induktivantenne enthält, die für die Übertragung wenigstens eines Netzfrequenzbandes ausgelegt ist und
- die über ein Antennenkabel und eine Steckverbindung an eine Außenantenne des Kraftfahrzeugs anschließbar ist.

Die WO 2009/012033 A1 offenbart ein Medien-Portal für ein Fahrzeug, welches eine Struktur innerhalb eines Fahrzeuginnenraums umfasst, die einen Hohlraum definiert. Der Hohlraum ist in seiner Größe selektiv variabel, um eine tragbare elektronische Vorrichtung zu halten. Ein Sensor ist so konfiguriert, um die Anwesenheit der tragbaren elektronischen Vorrichtung in dem Hohlraum zu erfassen. Ein induktives Ladegerät ist positioniert, um ein sich änderndes Magnetfeld in dem Hohlraum zu erzeugen, um induktiv eine Batterie der tragbaren elektronischen Vorrichtung zu laden.

Die US 2009/0270727 A1 offenbart ein Ultraschalldiagnosesystem mit einem tabletartigen elektronischen Gerät für Ultraschalldiagnose und einer Dockingstation zur Aufnahme des elektronischen Geräts. Die Dockingstation weist einen Behälterabschnitt und einen Niederhaltabschnitt auf.

Es stellt sich das technische Problem, eine Haltevorrichtung und ein Verfahren zur Herstellung einer Haltevorrichtung für drahtlos koppelbare Endgeräte mit verschiedenen Dimensionen zu schaffen, welche eine zuverlässige und qualitätsoptimierte drahtlose Übertragung von elektrischer Energie und/oder drahtlose Kommunikation zu/mit dem Endgerät ermöglichen, wobei eine Bedienbarkeit der Haltevorrichtung in Bezug auf das Einlegen und Entnehmen des Endgeräts vereinfacht wird.

Die Lösung des technischen Problems ergibt sich durch die Gegenstände mit den Merkmalen der Ansprüche 1 und 14. Weitere vorteilhafte Ausgestaltungen der Erfindung ergeben sich aus den Unteransprüchen.

Es ist eine Grundidee der Erfindung, dass eine Haltevorrichtung mit einem variablen Aufnahmevolumen geschaffen wird, welche ein in das Aufnahmevolumen eingebrachtes Endgerät in einer vorbestimmten Position und/oder Orientierung halten oder mechanisch fixieren kann, wobei ein einfaches, insbesondere einhändiges, Einlegen des Endgeräts in das und Entnehmen des Endgeräts aus dem Aufnahmevolumen erfolgen kann. Vorgeschlagen wird eine Haltevorrichtung für ein drahtlos koppelbares Endgerät, insbesondere ein Mobiltelefon.

Die drahtlose Kopplung kann hierbei eine drahtlose Kopplung zur Übertragung von elektrischer Energie zum Endgerät, z.B. zum Laden eines Energiespeichers des Endgeräts und/oder zum Betreiben des Endgeräts, sein. Insbesondere kann die Haltevorrichtung eine Haltevorrichtung für ein induktiv ladbares Endgerät sein. Alternativ oder kumulativ kann die drahtlose Kopplung eine Kopplung zur drahtlosen Kommunikation des Endgeräts mit weiteren Geräten sein.

Die Haltevorrichtung umfasst mindestens einen Stativteil und mindestens einen beweglichen Teil. Der Stativteil kann hierbei ein ortsfest angeordneter Teil sein. Der Stativteil kann in einem Fahrzeug, insbesondere in einem Automobil, angeordnet sein. Beispielsweise kann der Stativteil an einer Innenverkleidung, z.B. an einer Innenverkleidung einer Fahrzeugtür, oder an einer Frontkonsole, befestigt sein oder von dieser Innenverkleidung ausgebildet werden. Es ist auch möglich, den Stativteil an einer Mittelkonsole, z.B. an einer Seitenwand einer Mittelkonsole, anzuordnen.

Der Stativteil kann hierbei mittels einer Befestigungsvorrichtung an einem Fahrzeugteil, z.B. an einer Konsole, befestigt werden, insbesondere lösbar befestigt werden.

Der Stativteil weist mindestens eine Auflagefläche oder ein Auflageelement auf oder bildet diese aus. Die Auflagefläche oder das Auflageelement kann hierbei eine vorbestimmte Größe aufweisen. Insbesondere kann die Größe der Auflagefläche gleich der Größe des Endgeräts sein oder größer als die Größe des Endgeräts sein. Es ist aber auch vorstellbar, dass die Größe der Auflagefläche kleiner als die Größe des Endgeräts ist. Die Auflagefläche ist insbesondere eine ebene Auflagefläche.

Insbesondere kann eine Breite der Auflagefläche größer als eine vorbestimmte maximale Breite und/oder eine Länge der Auflagefläche größer als eine vorbestimmte maximale Länge sein, wobei die maximale Breite und/oder Länge abhängig von einer Größe der zu fixierenden Endgeräte gewählt werden kann.

Die Auflagefläche kann hierbei von mindestens einer Seitenwand begrenzt werden oder seitenwandlos ausgebildet sein.

Die Haltevorrichtung umfasst weiter mindestens eine stativseitig angeordnete Leiterstruktur. Die Leiterstruktur ist hierbei eine primärseitige Leiterstruktur, insbesondere eine Windungs- oder Spulenanordnung, zur Erzeugung eines elektromagnetischen Wechselfeldes für eine induktive Übertragung von elektrischer Energie an das Endgerät. In diesem Falle kann das Endgerät eine sekundärseitige Leiterstruktur, insbesondere eine Windungs- oder Spulenanordnung, zum Empfangen des elektromagnetischen Wechselfeldes umfassen.

Alternativ ist Leiterstruktur eine Antennenstruktur für eine uni- oder bidirektionale drahtlose Kommunikation mit dem Endgerät.

Die Haltevorrichtung kann aber auch sowohl eine stativseitige Leiterstruktur zur induktiven Übertragung von elektrischer Energie als auch eine weitere stativseitige Leiterstruktur zur drahtlosen Kommunikation umfassen. Stativseitig bedeutet hierbei, dass die stativseitige Leiterstruktur ebenfalls ortsfest angeordnet ist. Beispielsweise kann diese an dem Stativteil befestigt sein oder ein integraler Teil des Stativteils sein. Auch kann die Leiterstruktur auf oder in einer Trägerstruktur, z.B. einer Platine, einem Gehäuse oder in einem Leiterführungselement, angeordnet sein, wobei die Trägerstruktur an dem Stativteil befestigt ist oder mit einer vorbestimmten Position und/oder Orientierung zu dem Stativteil angeordnet ist.

Somit kann die Haltevorrichtung Mittel zur drahtlosen Energieübertragung umfassen. Alternativ oder kumulativ kann die Haltevorrichtung mindestens ein Mittel zur drahtlosen Signalübertragung zwischen dem Endgerät und der Haltevorrichtung, umfassen, wobei die Signalübertragung insbesondere einer drahtlosen Kommunikation dienen kann. Beispielsweise kann die Haltevorrichtung ein erstes Mittel zur drahtlosen Signalübertragung zwischen einer Antenne des Endgeräts und der Haltevorrichtung umfassen. Diese Signalübertragung kann beispielsweise verwendet werden, um Kommunikationssignale des Endgeräts an eine Außenantenne oder von einer Außenantenne des Fahrzeugs an das Endgerät zu übertragen. Weiter kann die die Haltevorrichtung ein weiteres Mittel zur drahtlosen Übertragung von Datensignalen und/oder Steuersignalen zwischen dem Endgerät und der Haltevorrichtung umfassen. Diese können beispielsweise verwendet werden, um das Endgerät fahrzeugseitig steuern oder bedienen zu können oder fahrzeugseitig Information des Endgeräts nutzen, z.B. anzeigen, zu können.

Weiter weist der bewegliche Teil mindestens ein Andruckelement auf. Das Andruckelement kann beispielsweise als Andruckfläche ausgebildet sein. Alternativ kann das Andruckelement auch punktförmig oder linienförmig ausgebildet sein. Das Andruckelement dient zur Herstellung eines mechanischen Kontakts des beweglichen Teils mit dem Endgerät. Der bewegliche Teil der Haltevorrichtung ist derart beweglich an dem Stativteil befestigt oder mit diesem verbunden, dass ein variabler Abstand zwischen der Auflagefläche und dem Andruckelement einstellbar ist. Ein Volumen oder Raum zwischen der Auflagefläche und dem Andruckelement ist hierbei ein Teil eines Aufnahmevolumens, in welches das Endgerät eingebracht werden kann oder aus welchem das Endgerät entnommen werden kann. Durch den variablen Abstand können Endgeräte mit verschiedenen Dimensionen, insbesondere Dicken, zwischen der Auflagefläche und dem Andruckelement angeordnet werden. Die Auflagefläche dient hierbei zur Herstellung eines mechanischen Kontakts des Stativteils mit dem Endgerät, wenn dieses in dem Aufnahmevolumen angeordnet ist.

Insbesondere kann das mindestens eine Andruckelement mit einer Vorderseite des Endgeräts in mechanischen Kontakt treten, wobei die Vorderseite des Endgeräts ein Display aufweisen kann. In diesem Fall kann eine Rückseite des Endgeräts, also eine der Vorderseite gegenüberliegende Seite, auf der Auflagefläche aufliegen.

Der bewegliche Teil kann hierbei translations- und/oder drehfest an dem Stativteil befestigt sein, wobei der variable Abstand aufgrund einer elastischen Verformung des beweglichen Teils einstellbar ist. Wie nachfolgend aber noch näher erläutert, ist der bewegliche Teil bevorzugt derart an dem Stativteil befestigt, dass der bewegliche Teil mit einer Drehbewegung und/oder einer Translationsbewegung bewegbar ist, wobei der variable Abstand aufgrund der Beweglichkeit des beweglichen Teils einstellbar ist. Dies schließt aber nicht aus, dass der bewegliche Teil zusätzlich elastisch verformbar ausgebildet ist, wobei der variable Abstand zusätzlich aufgrund einer elastischen Verformung des beweglichen Teils einstellbar ist.

Das bewegliche Teil kann hierbei derart an dem Stativteil befestigt sein, dass ein eingestellter Abstand ein stabiler Abstand ist. Dies bedeutet, dass der eingestellte Abstand nur durch eine Betätigung des beweglichen Teils mit einer Betätigungskraft, die gleich einer oder größer als eine vorbestimmte Kraft ist, verändert werden kann. So kann ein Endgerät zwischen der Auflagefläche und dem beweglichen Teil angeordnet werden und der bewegliche Teil derart bewegt werden, dass das Endgerät zwischen die Auflagefläche oder das Auflageelement und das Andruckelement geklemmt wird, wobei sowohl die Auflagefläche als auch das Andruckelement in mechanischem Kontakt mit dem Endgerät sind.

Beispielsweise kann das bewegliche Element, insbesondere das Andruckelement, in einer vertikalen Richtung auf die Auflagefläche zubewegt werden bis ein mechanischer Kontakt des Endgeräts sowohl mit der Auflagefläche als auch mit dem Andruckelement hergestellt ist. Die vertikale Richtung beschreibt eine Richtung, die senkrecht zur Auflagefläche orientiert ist. Hierdurch kann ein Endgerät zwischen die Auflagefläche und das Andruckelement geklemmt werden. Eine Bewegung des beweglichen Teils in vertikaler Richtung von der Auflagefläche weg ist hierbei nur möglich, wenn die Betätigungskraft auf das bewegliche Teil aufgebracht wird. Eine Bewegung in vertikaler Richtung umfasst auch den Fall, dass das bewegliche Teil, insbesondere das Andruckelement, in einer Richtung auf die Auflagefläche zubewegt wird, die zumindest einen Anteil umfasst, der in vertikaler Richtung orientiert ist. Beispielsweise kann, wie nachfolgend noch näher erläutert, das bewegliche Teil eine Drehbewegung ausführen, die um eine Rotationsachse ausgeführt wird, wobei die Rotationsachse parallel zur Auflagefläche verlaufen kann. Alternativ oder kumulativ kann der bewegliche Teil eine Translationsbewegung ausführen. Beispielsweise kann kann die Bewegung, insbesondere die Translationsbewegung, in vertikaler Richtung auch eine Bewegung sein, die ausschließlich in oder entgegen der vertikalen Richtung orientiert ist. Hierdurch kann in vorteilhafter Weise eine stabile Halterung eines zwischen der Auflagefläche und dem Andruckelement angeordneten Endgerätes erfolgen. Zu beachten ist, dass in einer solchen Konfiguration nicht zwingend eine, insbesondere also keine, zusätzliche in Richtung der Auflagefläche wirkende Kraft auf das Endgerät erzeugt werden muss, wenn das Endgerät zwischen der Auflagefläche und dem Andruckelement angeordnet ist.

Der Abstand zwischen Auflagefläche und Andruckelement kann hierbei in der vorhergehend erwähnten vertikalen Richtung gemessen werden.

Die vorgeschlagene Haltevorrichtung ermöglicht in vorteilhafter Weise eine stabile Halterung von Endgeräten mit unterschiedlichen Bauformen und Baugrößen. Ebenfalls ist eine einfache Bedienung, insbesondere eine einhändige Bedienung, der Haltevorrichtung beim Einlegen und Entnehmen des Endgeräts möglich. So kann ein Benutzer den beweglichen Teil z.B. in vertikaler Richtung von der Auflagefläche weg bewegen, das Endgerät zwischen Auflagefläche und Andruckelement anordnen und hiernach das bewegliche Teil auf die Auflagefläche zubewegen, bis ein mechanischer Kontakt oder Kraftschluss zwischen dem Andruckelement und dem Endgerät sowie dem Endgerät und der Auflagefläche hergestellt ist. In diesem Fall liegt das Endgerät auf der vorzugsweise ebenen Auflagefläche auf, wodurch das Endgerät sich in einer gewünschten Entfernung von der vorhergehend erläuterten Leiterstruktur befindet.

Durch die Haltevorrichtung wird in vorteilhafter Weise eine lösbare Fixierung für eine Vielzahl von Endgeräten mit verschiedenen Dimensionen ermöglicht, die, insbesondere auch im Fahrbetrieb, des Fahrzeugs eine Fixierung des Endgeräts derart ermöglicht, dass keine oder nur eine geringe Änderung der Ausrichtung und/oder Position des Endgeräts erfolgt.

Die vorgeschlagene Haltevorrichtung kann hierbei derart z.B. in einem Fahrzeug angeordnet werden, dass die Auflagefläche eine horizontale oder eine vertikale Fläche ist. Somit ergibt sich durch die vorgeschlagene Haltevorrichtung die Möglichkeit einer horizontalen oder vertikalen Halterung des Endgeräts. Hierbei kann eine horizontale Auflagefläche orthogonal zu einer Gierachse des Fahrzeugs orientiert sein. Weiter kann die Gierachse parallel zu einer vertikalen Auflagefläche orientiert sein. Auch kann die vertikale Auflagefläche orthogonal zu einer Rollachse oder einer Nickachse des Fahrzeugs orientiert sein. Auch kann die Auflagefläche eine schiefe Fläche sein, wobei zumindest ein Anteil mindestens eines Vektors, der die Ebene aufspannt, die die Auflagefläche umfasst, parallel zur Gierachse orientiert ist.

Die Gierachse, Rollachse und Nickachse können hierbei ein Fahrzeugkoordinatensystem definieren. In anderen Worte kann die vorgeschlagene Haltevorrichtung derart im Fahrzeug angeordnet sein, dass in Bezug auf das Fahrzeugkoordinatensystem das Aufnahmevolumen nach oben oder zumindest teilweise nach oben hin geöffnet ist, wodurch ein Endgerät von oben in das Aufnahmevolumen eingebracht werden kann. Alternativ oder kumulativ kann die vorgeschlagene Haltevorrichtung derart im Fahrzeug angeordnet sein, dass in Bezug auf das Fahrzeugkoordinatensystem das Aufnahmevolumen nach vorne oder hinten oder zumindest teilweise nach vorne oder hinten hin und/oder zu einer Fahrzeugseite oder zumindest teilweise zu einer Fahrzeugseite hin geöffnet ist.

Erfindungsgemäß ist der bewegliche Teil derart beweglich an dem Stativteil befestigt ist, dass der bewegliche Teil mit einer Drehbewegung bewegbar ist. In anderen Worten bedeutet dies, dass der bewegliche Teil schwenkbar sein kann. Eine Rotationsachse, um welche die Drehbewegung ausführbar ist, kann insbesondere parallel zur Auflagefläche orientiert sein oder verlaufen.

Z.B. kann der bewegliche Teil drehbar am Stativteil gelagert sein, beispielsweise mittels mindestens einer Lagereinrichtung, beispielsweise mittels einer Radiallagereinrichtung. Erfindungsgemäß weist der bewegliche Teil mindestens einen Zapfen auf, wobei eine zentrale Mittellinie oder Symmetrieachse des Zapfens parallel zur Rotationsachse verläuft, wobei der Zapfen drehbar am Stativteil gelagert ist. Der Zapfen kann hierbei z.B. mittels einer Gleitlagereinrichtung oder einer Wälzlagereinrichtung gelagert sein.

Beispielsweise kann sich der mindestens eine Zapfen in eine Ausnehmung im Stativteil erstrecken, beispielsweise in ein kreisförmige Ausnehmung oder eine längliche Ausnehmung. Die Ausnehmung kann hierbei von einer Sackbohrung oder einer Nut ausgebildet werden. Auch kann die Ausnehmung als Durchgangsloch ausgebildet sein.

Kumulativ ist der bewegliche Teil derart beweglich an dem Stativteil befestigt, dass der bewegliche Teil mit einer Translationsbewegung bewegbar ist.

Die Translationsbewegung kann eine Linearbewegung sein. Zumindest ein Anteil der Translationsbewegung kann in oder entgegen der vertikalen Richtung orientiert sein. Vorzugsweise ist die Translationsbewegung ausschließlich in oder entgegen der vertikalen Richtung orientiert.

Es ist möglich, dass der bewegliche Teil drehfest, jedoch mit der Translationsbewegung bewegbar an dem Stativteil befestigt ist. Auch ist es möglich, dass der bewegliche Teil translationsfest, jedoch mit der Drehbewegung bewegbar an dem Stativteil befestigt ist. Weiter ist möglich, dass der bewegliche Teil sowohl mit der Translationsbewegung als auch mit der Drehbewegung beweglich an dem Stativteil befestigt ist. In diesem Fall ist es möglich, dass die Drehbewegung und die Translationsbewegung gleichzeitig oder sequentiell ausführbar sind.

Selbstverständlich kann der bewegliche Teil und/oder der Stativteil Führungsmittel zur Führung der Drehbewegung und/oder der Rotationsbewegung aufweisen.

Der bewegliche Teil kann insbesondere derart an dem Stativteil befestigt sein, dass entlang einer Trajektorie der Drehbewegung und/oder der Translationsbewegung mindestens eine, vorzugsweise mehrere, Rastposition(en) angeordnet oder vorgesehen sind.

Dass der bewegliche Teil mit einer Drehbewegung bewegbar ist, kann in diesem Fall bedeuten, dass alle Rastpositionen einer Drehbewegung auf einer Kreislinie liegen. Dass der bewegliche Teil mit einer Translationsbewegung bewegbar ist, kann in diesem Fall bedeuten, dass alle Rastpositionen einer Translationsbewegung auf einer Geraden liegen.

In einer Rastposition kann der bewegliche Teil nur bei einer Betätigung des beweglichen Teils mit einer Betätigungskraft, die gleich einer oder größer als eine vorbestimmte Lösekraft ist, aus der Rastposition heraus bewegbar sein. Die Lösekraft kann insbesondere größer als eine Bewegungskraft sein, die zur Bewegung des beweglichen Teils entlang der entsprechenden Trajektorie auf das bewegliche Teil ausgeübt werden muss.

Hierzu können geeignete Mittel zur Fixierung, beispielsweise Rasteinrichtungen oder Rastmittel, am beweglichen Teil und/oder am Stativteil vorgesehen sein.

Beispielsweise kann die Linearbewegung mindestens zwei, beispielsweise drei, Rastpositionen aufweisen, wobei die Drehbewegung keine Rastpositionen aufweist.

Es ist weiter möglich, dass der bewegliche Teil entlang einer Trajektorie der Drehbewegung und/oder der Translationsbewegung in verschiedene Stellungen bewegbar ist. Diese Stellungen können z.B. durch die vorhergehend erläuterten Rastpositionen festgelegt sein. So kann der bewegliche Teil beispielsweise in eine Freigabestellung und in eine Einspannstellung bewegbar sein.

Hierdurch ergibt sich in vorteilhafter Weise eine besonders gute und einfach bedienbare Einstellung des Aufnahmevolumens.

In einer weiteren Ausführungsform ist die Leiterstruktur mit einem vorbestimmten Abstand von der Auflagefläche und/oder mit einer vorbestimmten Orientierung zur Auflagefläche angeordnet. Der Abstand kann hierbei z.B. in der vorhergehend erläuterten vertikalen Richtung gemessen werden. Vorzugsweise kann die Leiterstruktur in einem Abstand von 1 mm bis 3 mm in vertikaler Richtung von der Auflagefläche beabstandet angeordnet sein. Hierdurch wird gewährleistet, dass ein optimaler Abstand für z.B. eine induktive Übertragung von elektrischer Energie zwischen einem auf der Auflagefläche angeordneten Endgerät und der Leiterstruktur vorhanden ist. Hierdurch kann eine Qualität einer induktiven Energieübertragung verbessert werden.

In einer bevorzugten Ausführungsform ist der bewegliche Teil derart beweglich an dem Stativteil befestigt, dass eine Rotationsachse der Drehbewegung mit der Translationsbewegung bewegbar ist. Die Rotationsachse der Drehbewegung bezeichnet die Achse, um die die Drehbewegung ausführbar ist.

So kann z.B. die Rotationsachse mit einer Translationsbewegung in verschiedene Rastpositionen der Translationsbewegung bewegt werden, wobei in jeder Rastposition eine Rotation des beweglichen Teils um die Rotationsachse möglich ist.

Hierdurch ergibt sich in vorteilhafter Weise eine besonders gute Bedienbarkeit, da durch einen Betätigungsvorgang, beispielsweise die Betätigung durch einen Finger eines Nutzers, sowohl die Drehbewegung als auch die Translationsbewegung ausgeführt werden kann.

In einer weiteren Ausführungsform umfasst die Haltevorrichtung mindestens ein Mittel zur Krafterzeugung, wobei das Mittel zur Krafterzeugung derart ausgebildet und/oder angeordnet ist, dass auf das bewegliche Teil eine in Richtung der Auflagefläche orientierte Kraft wirkt, wenn ein Abstand zwischen der Auflagefläche und dem Andruckelement größer als Null oder größer als ein vorbestimmter Abstand, der größer als Null ist, ist. Ein Abstand von Null bedeutet hierbei, dass das Andruckelement in mechanischem Kontakt mit der Auflagefläche steht. Das Mittel zur Krafterzeugung kann auch derart ausgebildet und/oder angeordnet sein, dass auf das bewegliche Teil eine in Richtung der Auflagefläche orientierte Kraft ebenfalls dann wirkt, wenn der Abstand Null ist.

Das Mittel zur Krafterzeugung kann ein aktives oder ein passives Mittel zur Krafterzeugung sein. Ein aktives Mittel zur Krafterzeugung bezeichnet hierbei ein Mittel zur Krafterzeugung, welches eine Kraft unter Verbrauch externer Energie, z.B. elektrischer Energie, erzeugt. Beispielsweise kann ein aktives Mittel zur Krafterzeugung ein Elektromotor, beispielsweise ein Linearmotor, oder Piezoaktor sein.

Vorzugsweise ist das Mittel zur Krafterzeugung ein passives Mittel zur Krafterzeugung, welches eine Kraft ohne Zufuhr von externer, z.B. elektrischer, Energie erzeugen kann.

Wird ein Endgerät zwischen der Auflagefläche und dem Andruckelement angeordnet, so ist ein Abstand zwischen der Auflagefläche und dem Andruckelement größer als Null oder größer als der vorbestimmte Abstand. Dieser kann z.B. kleiner als eine minimale Dicke eines zu haltenden Endgeräts sein. In diesem Fall wirkt eine in Richtung der Auflagefläche orientierte Kraft auf das bewegliche Teil, wodurch das bewegliche Teil in Richtung der Auflagefläche bewegt wird, bis das Andruckelement an dem Endgerät anliegt. In diesem Fall wirkt jedoch auch im eingelegten Zustand des Endgeräts, also wenn das Endgerät zwischen der Auflagefläche und dem Andruckelement angeordnet ist, eine Anpress- oder Andruckkraft auf das Endgerät, durch welche das Endgerät an die Auflagefläche angedrückt oder angepresst und damit auch stabil gehaltert wird. Vorzugsweise ist eine Höhe der in Richtung der Auflagefläche orientierten Kraft derart zu wählen, dass das Endgerät nicht beschädigt wird.

Die in Richtung der Auflagefläche orientierte Kraft kann hierbei auch zumindest teilweise durch ein Drehmoment bereitgestellt werden oder ein Drehmoment bezeichnen, welches auf das bewegliche Teil derart ausgeübt wird, dass es, insbesondere mit einer Drehbewegung, auf die Auflagefläche zubewegt wird. Insbesondere kann das Drehmoment um die vorhergehend erläuterte Rotationsachse ausgeübt werden. Hierdurch kann eine Drehbewegung des beweglichen Teils um die Rotationsachse auf die Auflagefläche zu bewirkt werden.

In diesem Fall kann der Abstand auch einen Winkelabstand zwischen der Auflagefläche und dem beweglichen Teil bezeichnen, wobei der Winkelabstand um die vorhergehend erläuterte Rotationsachse gemessen werden kann.

Somit ist auch eine Haltevorrichtung beschrieben, die mindestens ein Mittel zur Krafterzeugung umfasst, wobei das Mittel zur Krafterzeugung derart ausgebildet und/oder angeordnet ist, dass auf das bewegliche Teil ein(e) in Richtung der Auflagefläche orientierte Kraft und/oder orientiertes Moment wirkt, wenn ein Winkelabstand zwischen der Auflagefläche und dem Andruckelement größer als Null oder größer als ein vorbestimmter Winkelabstand, der größer als Null ist, ist. Ein Winkelabstand von Null bedeutet hierbei, dass das Andruckelement in mechanischem Kontakt mit der Auflagefläche steht. Das Mittel zur Krafterzeugung kann auch derart ausgebildet und/oder angeordnet sein, dass auf das bewegliche Teil ein in Richtung der Auflagefläche orientiertes Drehmoment ebenfalls dann wirkt, wenn der Winkelabstand Null ist oder dem vorbestimmten Abstand entspricht.

Es ist auch möglich, dass die Haltevorrichtung mindestens ein Mittel zur Krafterzeugung umfasst, wobei das Mittel zur Krafterzeugung derart ausgebildet und/oder angeordnet ist, dass auf das bewegliche Teil ein(e) in Richtung der Auflagefläche orientierte Kraft und/oder orientiertes Drehmoment wirkt, durch welches eine Drehbewegung des beweglichen Teils um die Rotationsachse auf die Auflagefläche zu bewirkbar ist, insbesondere wenn ein Winkelabstand zwischen der Auflagefläche und dem Andruckelement größer als Null oder größer als ein vorbestimmter Winkelabstand, der größer als Null ist, ist. Alternativ oder kumulativ kann die Haltevorrichtung mindestens ein Mittel zur Krafterzeugung umfassen, wobei das Mittel zur Krafterzeugung derart ausgebildet und/oder angeordnet ist, dass auf das bewegliche Teil eine in Richtung der Auflagefläche orientierte Kraft wirkt, durch welches eine Translationsbewegung des beweglichen Teils auf die Auflagefläche zu bewirkbar ist, insbesondere wenn ein Abstand zwischen der Auflagefläche und dem Andruckelement größer als Null oder größer als ein vorbestimmter Abstand, der größer als Null ist, ist.

Somit kann durch die Kraft, die durch das mindestens eine Mittel zur Krafterzeugung erzeugbar ist, die vorhergehend erläuterte Translationsbewegung und/oder Drehbewegung bewirkbar sein. Auch kann die Haltevorrichtung ein erstes Mittel und ein weiteres Mittel zur Krafterzeugung umfassen, wobei durch die Kraft, die durch das erste Mittel zur Krafterzeugung erzeugbar ist, die vorhergehend erläuterte Translationsbewegung und durch die Kraft, die durch das weitere Mittel zur Krafterzeugung erzeugbar ist, die vorhergehend erläuterte Translationsbewegung bewirkbar ist. Auch kann nur ein Mittel zur Krafterzeugung vorgesehen sein, wobei durch die von diesem Mittel erzeugte Kraft entweder die Drehbewegung oder die Translationsbewegung bewirkbar ist. In diesem Fall kann die verbleibende Bewegung eine freie Bewegung sein.

Hierdurch wird in vorteilhafter Weise die Stabilität der Halterung und somit auch die Zuverlässigkeit und Robustheit der Positionierung des Endgeräts weiter verbessert. Auch wird das Einlegen des Endgeräts in die Haltevorrichtung erleichtert, da ein Benutzer in einem ersten Schritt das bewegliche Teil von der Auflagefläche wegbewegt, das Endgerät zwischen Auflagefläche und Andruckelement anordnet und hiernach das bewegliche Teil einfach loslassen kann, wonach dieses automatisch das Endgerät zwischen Auflagefläche und Andruckelement klemmt.

In einer weiteren Ausführungsform ist das Mittel zur Krafterzeugung als Federelement ausgebildet, wobei der Stativteil und der bewegliche Teil über das Federelement mechanisch verbunden sind. Das Federelement kann beispielsweise als Helixfeder oder Metallfeder ausgebildet sein. Auch kann das Federelement aus einem elastischen Material, beispielsweise aus Gummi, ausgebildet sein. Das Federelement kann vorgespannt sein, wenn ein Abstand zwischen der Auflagefläche und dem Andruckelement Null oder größer als der vorhergehend erläuterte Abstand ist. Das Federelement ist hierbei ein Beispiel für ein passives Mittel zur Krafterzeugung.

Weiter ist es möglich, dass das Federelement als Blattfeder oder Schenkelfeder ausgebildet ist. Auch kann das Federelement als Torsionsfeder ausgebildet sein, insbesondere wenn durch das Mittel zur Krafterzeugung ein Drehmoment bereitgestellt wird.

Hierdurch ergibt sich in vorteilhafter Weise eine besonders einfache Ausbildung des Mittels zur Krafterzeugung, welches eine stabile und zuverlässige Halterung eines Endgeräts ermöglicht.

Weiter kann die Haltevorrichtung mindestens ein Dämpfungsmittel umfassen, wobei die Dämpfungsmittel derart ausgebildet und/oder angeordnet sind, dass eine Geschwindigkeit einer Drehbewegung und/oder einer Translationsbewegung des beweglichen Teils, insbesondere eine Bewegung auf die Auflagefläche zu, während der Bewegung verringert wird. Auch kann die Geschwindigkeit durch das mindestens eine Dämpfungsmittel auf eine maximale Geschwindigkeit begrenzt werden.

In einer weiteren Ausführungsform weist der bewegliche Teil Führungsmittel und der Stativteil korrespondierende Führungsgegenmittel auf oder bildet diese aus. Durch die Führungsmittel und die korrespondierenden Führungsgegenmittel ist das bewegliche Teil derart führbar, dass das mindestens eine Andruckelement mit einer Linearbewegung hin zur Auflagefläche oder weg von der Auflagefläche bewegbar ist. Die Linearbewegung kann insbesondere eine Bewegung in oder entgegen der vorhergehend erläuterten vertikalen Richtung sein. Die Führungsmittel und korrespondierenden Führungsgegenmittel wirken hierbei zusammen, um die erläuterte Bewegung zu führen. Insbesondere können die Führungsmittel als Führungsschlitze, Führungsstege und/oder Führungsnuten ausgebildet sein. Selbstverständlich können die Führungsmittel auch als Linearlager ausgebildet sein. Die Linearbewegung kann hierbei der vorhergehend erläuterten Translationsbewegung entsprechen.

Selbstverständlich kann der bewegliche Teil Führungsmittel und der Stativteil korrespondierende Führungsgegenmittel aufweisen oder ausbilden, die die vorhergehend erläuterte Drehbewegung führen.

Auch kann der bewegliche Teil Führungsmittel und der Stativteil korrespondierende Führungsgegenmittel aufweisen oder ausbilden, die die vorhergehend erläuterten Rastpositionen bereitstellen. Somit ist das bewegliche Teil durch die Führungsmittel und Führungsgegenmittel in die Rastpositionen bewegbar.

Erfindungsgemäß weist der Stativteil ein Langloch oder eine Nut auf. Zur Führung, insbesondere einer Translationsbewegung, wird ein geführter Teil, beispielsweise der vorhergehend erläuterte Zapfen, des beweglichen Teils in dem Langloch oder der Nut angeordnet.

Entlang einer Längsachse des Langlochs oder der Nut kann sich eine Breite des Langlochs oder der Nut verändern. Beispielsweise kann sich die Breite derart verändern, dass zumindest eine Längsseite des Langlochs oder der Nut einen wellenförmigen Verlauf aufweist. In dem wellenförmigen Verlauf können Wellentäler beispielsweise eine Rastposition bereitstellen, beispielsweise für einen Zapfen des beweglichen Teils.

Insbesondere kann sich die Breite derart verändern, dass die Breite in einem oder mehreren ersten Abschnitt(en) kleiner als ein Durchmesser des geführten Teils und in einem oder mehreren weiteren, insbesondere benachbarten, Bereich(en), größer als der oder gleich dem Durchmesser des geführten Teils ist, wobei diese Bereiche hierbei Rastpositionen bereitstellen. Insbesondere ist eine Bewegung des beweglichen Teils aus der Rastposition heraus nur dann möglich, falls eine Kraft derart auf das bewegliche Teil ausgeübt wird, dass das geführte Teil durch einen ersten Abschnitt bewegt werden kann. Hierzu kann das geführte Teil und/oder ein das Langloch oder die Nut aufweisender Abschnitt aus entsprechend nachgiebigem oder elastischem Material ausgebildet sein.

Hierdurch ergibt sich in vorteilhafter Weise eine weiter vereinfachte Bedienung der Haltevorrichtung, da die Führungsmittel bzw. die korrespondierenden Führungsgegenmittel nur eine Bewegung des beweglichen Teils in eine Richtung zulassen und ein Benutzer daher weniger Aufmerksamkeit bei einer Bewegung des beweglichen Teils aufbringen muss.

In einer weiteren Ausführungsform weist der bewegliche Teil und/oder der Stativteil mindestens ein Anschlagelement auf oder bildet diese(s) aus, wobei durch das Anschlagelement eine Bewegung, insbesondere die vorhergehend erläuterte Linearbewegung, des beweglichen Teils begrenzt wird. Hierdurch wird in vorteilhafter Weise die Bedienbarkeit der Haltevorrichtung weiter vereinfacht, da durch Anschlagelemente z.B. ein ungewolltes Lösen des beweglichen Teils vom Stativteil vermieden werden kann. Selbstverständlich kann durch ein Anschlagelement auch die vorhergehend erläuterte Drehbewegung begrenzt werden.

In einer weiteren Ausführungsform weist das bewegliche Teil eine Vorderwand auf. Die Vorderwand bezeichnet hierbei eine in vertikaler Richtung von der Auflagefläche beabstandete Wand des beweglichen Teils, die z.B. parallel zur Auflagefläche verlaufen kann. Die Vorderwand weist mindestens eine Andruckfläche auf oder bildet diese aus. Dies kann auch bedeuten, dass nur ein Teil der Vorderwand die Andruckfläche aufweist oder ausbildet. Die Andruckfläche ist parallel zur Auflagefläche orientiert. Somit wird das Andruckelement durch eine Andruckfläche der Vorderwand ausgebildet. Das Endgerät kann somit zwischen die Auflagefläche und die Andruckfläche eingebracht werden, wobei das Endgerät zwischen die Auflagefläche und die Andruckfläche geklemmt und somit gehaltert wird.

Der bewegliche Teil kann neben der Vorderwand auch Seitenwände und/oder einen Bodenteil bzw. eine Bodenwand aufweisen. Durch die Auflagefläche, die Seitenwände, den Bodenteil und die Vorderwand kann hierbei ein Aufnahmevolumen eingeschlossen werden, in welches das Endgerät eingelegt wird. Das Aufnahmevolumen ist hierbei zu mindestens einer Seite hin, beispielsweise zu der dem Bodenteil gegenüberliegenden Stirnseite hin geöffnet, sodass das Endgerät von dieser Stirnseite her in das Aufnahmevolumen einlegbar oder aus diesem entnehmbar ist.

Die Seitenteile oder Seitenwände können hierbei senkrecht zur Vorderwand orientiert angeordnet sein. Auch die Bodenwand oder das Bodenteil kann senkrecht orientiert zur Vorderwand und zur mindestens einen Seitenwand angeordnet sein. Hierdurch ergibt sich ein quaderförmiges Aufnahmevolumen.

Das Aufnahmevolumen kann hierbei ein Volumen mit einer variablen Tiefe sein, wobei die Tiefe des Volumens entlang der vertikalen Richtung zwischen der Auflagefläche und der Andruckfläche gemessen wird.

Durch die Ausbildung des Andruckelements als Andruckfläche ergibt sich eine möglichst gleichmäßige Verteilung einer Andruckkraft während der Halterung des Endgeräts auf das Endgerät, wodurch die Gefahr einer Beschädigung des Endgeräts bei der Halterung verringert wird. Durch das Vorsehen von Seitenteilen und/oder einem Bodenteil kann in vorteilhafter Weise ein Herausfallen des Endgeräts aus dem Aufnahmevolumen verhindert werden, beispielsweise ein versehentliches Herausfallen während der Entnahme des Endgeräts aus dem Aufnahmevolumen.

In einer weiteren Ausführungsform weist der bewegliche Teil eine Vorderwand auf, wobei die Vorderwand, insbesondere eine Oberfläche der Vorderwand, eine vorbestimmte Anzahl von, insbesondere mindestens zwei, Andruckabschnitten aufweist oder diese ausbildet.

Ein Andruckabschnitt bezeichnet hierbei einen Abschnitt der Vorderwand, der in mechanischen Kontakt mit einem in das Aufnahmevolumen eingelegten Endgerät tritt. Insbesondere können in diesem Fall nur die Andruckabschnitte und nicht die gesamte Vorderwand oder ein großer Flächenabschnitt der Vorderwand in mechanischen Kontakt mit einem in das Aufnahmevolumen eingelegten Endgerät treten.

Ein Andruckabschnitt kann hierbei punktförmig, linienförmig oder flächig ausgebildet sein.

Die Andruckabschnitte können hierbei in einer vorbestimmten Anordnung auf der Vorderwand angeordnet sein, z.B. mit einem vorbestimmten Abstand zueinander. So können z.B. Andruckabschnitte in mechanischen Kontakt mit einem in das Aufnahmevolumen eingelegten Endgerät treten, wobei ein Bereich zwischen zwei, insbesondere benachbarten, Andruckabschnitten, nicht in mechanischen Kontakt mit einem in das Aufnahmevolumen eingelegten Endgerät tritt, falls die Andruckabschnitte in mechanischen Kontakt mit dem in das Aufnahmevolumen eingelegten Endgerät sind. Beispielsweise können die Andruckabschnitte in einem Randbereich der Vorderwand angeordnet sein.

Hierdurch ergibt sich in vorteilhafter Weise, dass nur bestimmte Abschnitte des beweglichen Teils in mechanischen Kontakt mit einem eingelegten Endgerät treten können. Hierdurch kann z.B. ein ungewünschter mechanischer Kontakt zwischen Betätigungselementen des Endgeräts, beispielsweise haptisch bedienbaren Bedienelementen, und/oder einem Displaybereich des Endgeräts und dem beweglichen Teil vermieden werden.

In einer bevorzugten Ausführungsform weist zumindest ein Teil der Vorderwand eine gekrümmt ausgebildete Oberfläche auf oder bildet diese aus. Die gekrümmte Oberfläche kann hierbei eine oder zwei von Null verschiedene Hauptkrümmungen aufweisen. Insbesondere kann die gekrümmte Oberfläche konkav mit Bezug auf die Auflagefläche ausgebildet sein. Selbstverständlich kann die Vorderwand auch mehrere verschieden gekrümmte Oberflächenabschnitte, beispielsweise mit verschiedenen Hauptkrümmungen, aufweisen.

Hierdurch können in vorteilhafter Weise die vorhergehend erläuterten Andruckabschnitte ausgebildet werden.

In einer weiteren Ausführungsform ist zumindest ein Teil der Auflagefläche und/oder zumindest ein Teil der Vorderwand, insbesondere einer Oberfläche der Vorderwand, gerippt ausgebildet. So kann die Auflagefläche und/oder der zumindest ein Teil der Vorderwand Rippen aufweisen oder ausbilden, die parallel zu Seitenteilen oder Seitenwänden, also hin von einem Bodenteil zu einer dem Bodenteil gegenüberliegenden Stirnseite, verlaufen.

Alternativ oder kumulativ ist die Auflagefläche und/oder der zumindest eine Teil der Vorderwand gekörnt ausgebildet. In diesem Fall kann die entsprechende Fläche punktförmige, teilzylinderförmige oder teilkugelförmige erhabene Bereiche oder erhabene Bereich mit einer vorbestimmten Fläche aufweisen.

In beiden Fällen kann die Auflagefläche und/oder der zumindest eine Teil der Vorderwand nur über die erhabenen Bereiche, also z.B. eine Oberfläche der Rippen, in mechanischen Kontakt mit einem in das Aufnahmevolumen eingelegten Endgerät treten. Dies verringert eine Übertragung von thermischer Energie von der Auflagefläche hin zum Endgerät, beispielsweise von thermischer Energie, die durch eine primärseitige Leiterstruktur zum induktiven Laden erzeugt wird. Gleichzeitig kann jedoch eine ausreichend hohe Haftreibung erzeugt werden, so dass ein Verrutschen des Endgeräts im eingelegten Zustand vermieden wird.

Weiter alternativ oder kumulativ ist zumindest ein Teil der Auflagefläche und/oder zumindest ein Teil der Vorderwand gummiert. Hierdurch wird in vorteilhafter Weise ein hoher Haftreibungskoeffizient zwischen einem in das Aufnahmevolumen eingelegten Endgerät und der Auflagefläche und/oder der Vorderwand bereitgestellt, so dass ein Verrutschen des Endgeräts im eingelegten Zustand vermieden wird.

In einer weiteren Ausführungsform weist die Vorderwand des beweglichen Teils eine Aussparung auf. Die Aussparung kann hierbei als Schlitz oder Langloch ausgebildet sein. Somit weist die Vorderwand eine Öffnung auf, durch die ein Benutzer von außen in das Aufnahmevolumen hineingreifen kann. Hierdurch kann z.B. das Endgerät, wenn es in das Aufnahmevolumen eingelegt ist, durch den Benutzer bedient werden oder die Entnahme vereinfacht werden, da eine Zugänglichkeit zum Endgerät für den Benutzer erleichtert wird. Die Aussparung kann sich hierbei über eine gesamte Höhe der Vorderwand erstrecken. In diesem Fall besteht die Vorderwand aus zwei getrennten Teilwänden. Auch kann die Aussparung sich nur über einen Teil der Höhe der Vorderwand erstrecken.

Um die Aussparung herum, z.B. auf der der Vorderwand gegenüberliegenden Seite, kann das bewegliche Teil erhabene Bereiche aufweisen. Diese verhindern ein Abrutschen beim Betätigen des Endgeräts durch die Aussparung hindurch.

Auch ist es möglich, dass das Bodenteil oder die Bodenwand eine oder mehrere Aussparung(en) aufweist, insbesondere dass sich die vorhergehend genannte Aussparung der Vorderwand auch über zumindest einen Teil des Bodenteils oder der Bodenwand erstreckt. Hierdurch kann in vorteilhafter Weise ein in das Aufnahmevolumen eingelegtes Endgerät von unten betätigt oder verschoben werden, was eine Entnahme des Endgeräts aus dem Aufnahmevolumen erleichtert.

In einer weiteren Ausführungsform umfasst die Haltevorrichtung mindestens ein Polsterelement, wobei das Polsterelement am Stativteil oder am beweglichen Teil angeordnet ist. Insbesondere kann das Polsterelement derart angeordnet sein, dass es zwischen der Auflagefläche und dem Andruckelement angeordnet ist. Das Polsterelement dient hierbei als Kratzschutz. Insbesondere kann das Polsterelement eine vorbestimmte (geringe) Kratzfestigkeit aufweisen. Hierdurch kann in vorteilhafter Weise eine Beschädigung des Endgeräts, z.B. ein Zerkratzen des Endgeräts, durch die vorgeschlagene Haltevorrichtung vermieden werden. Auch ist vorstellbar, dass entsprechende Polsterelemente an einigen oder allen das Aufnahmevolumen einfassenden Flächen angeordnet sind. Z.B. kann ein Polsterelement auch an einem der vorhergehend genannten Seitenteile und/oder an einem Bodenteil angeordnet sein. Weiter kann zumindest ein Teil der Auflagefläche und/oder des beweglichen Teils, insbesondere das mindestens eine Andruckelement, elastisch verformbar ausgebildet sein. Hierdurch kann eine Beschädigung des Endgeräts vermieden werden.

Weiter vorgeschlagen wird ein Verfahren zur Herstellung einer Haltevorrichtung für ein drahtlos koppelbares Endgerät. Hierbei werden mindestens ein Stativteil und mindestens ein beweglicher Teil bereitgestellt, wobei der Stativteil mindestens eine ebene Auflagefläche für das Endgerät aufweist. Weiter wird mindestens eine Leiterstruktur bereitgestellt oder eine die Leiterstruktur aufweisende oder beinhaltende Trägerstruktur. Die mindestens eine Leiterstruktur wird stativseitig angeordnet, insbesondere an einer Rückseite des die Auflagefläche ausbildenden Teils des Stativteils.

Weiter wird der bewegliche Teil mit mindestens einem Andruckelement, insbesondere einer Andruckfläche, bereitgestellt und derart beweglich an dem Stativteil befestigt, dass ein variabler Abstand zwischen der Auflagefläche und dem Andruckelement einstellbar ist. Wie vorhergehend erläutert, kann ein z.B. durch einen Benutzer eingestellter Abstand ein stabiler Zustand sein.

Hierdurch ergibt sich in vorteilhafter Weise ein einfaches Verfahren zur Herstellung einer vorgeschlagenen Haltevorrichtung, insbesondere einer Haltevorrichtung gemäß einer der vorhergehend erläuterten Ausführungsformen.

Auch beschrieben wird ein Verfahren zur Halterung eines Endgeräts. Hierbei wird ein beweglicher Teil einer Haltevorrichtung von einem Stativteil der Haltevorrichtung in einer vertikalen Richtung von einer Auflagefläche des Stativteils wegbewegt. Hierbei kann der bewegliche Teil eine Drehbewegung und/oder eine Translationsbewegung ausführen. Es ist z.B. möglich, dass der bewegliche Teil während der Bewegung weg von der Auflagefläche ausschließlich eine Translationsbewegung, ausschließlich eine Drehbewegung oder aber sowohl ein Drehbewegung als auch eine Translationsbewegung ausführt. Diese Bewegung kann, z.B. durch manuelle Betätigung des beweglichen Teils, entgegen der Kraft bewirkt werden, die durch das vorhergehend erläuterte mindestens eine Mittel zur Krafterzeugung erzeugt wird.

Dann wird ein Endgerät räumlich zwischen der Auflagefläche und einem Andruckelement des beweglichen Teils angeordnet. Hiernach wird der bewegliche Teil in der vertikalen Richtung auf die Auflagefläche zubewegt, bis ein mechanischer Kontakt oder Kraftschluss zwischen dem Andruckelement des Stativteils und dem Endgerät sowie dem Endgerät und der Auflagefläche des beweglichen Teils hergestellt ist. Hierbei kann der bewegliche Teil eine Drehbewegung und/oder eine Translationsbewegung ausführen. Auch hierbei ist es möglich, dass der bewegliche Teil während der Bewegung hin zur Auflagefläche ausschließlich eine Translationsbewegung, ausschließlich eine Drehbewegung oder aber sowohl ein Drehbewegung als auch eine Translationsbewegung ausführt. Zumindest eine der Bewegungen kann durch die Kraft bewirkt werden, die durch das vorhergehend erläuterte mindestens eine Mittel zur Krafterzeugung erzeugt wird.

In diesem Zustand kann eine zusätzliche Andruckkraft durch das bewegliche Teil auf das Endgerät ausgeübt werden, z.B. durch das vorhergehend erläuterte Federelement.

Das Verfahren ist insbesondere mittels einer Haltevorrichtung ausführbar, die gemäß einer der vorhergehend erläuterten Ausführungsformen ausgebildet ist.

Hierdurch ergibt sich in vorteilhafter Weise eine besonders einfache Halterung eines Endgeräts in einer vorbestimmten Position, mit der insbesondere eine vorbestimmte Ausrichtung und Orientierung des Endgeräts zu einer Leiterstruktur, die ebenfalls am Stativteil der Haltevorrichtung angeordnet ist, einstellbar ist.

Die Erfindung wird anhand zweier Ausführungsbeispiele näher erläutert. Die Figuren zeigen:
- Fig. 1: einen Querschnitt durch eine Haltevorrichtung in einem ersten Beispiel,

- Fig. 2: eine Vorderansicht der in Fig. 1 dargestellten Haltevorrichtung,
- Fig. 3: eine Draufsicht auf ein Stativteil und einen beweglichen Teil einer Haltevorrichtung in einem zweiten Beispiel,

- Fig. 4: eine Vorderansicht des in Fig. 3 dargestellten beweglichen Teils,
- Fig. 5: eine Draufsicht auf das in Fig. 3 dargestellte bewegliche Teil,
- Fig. 6: eine perspektivische Ansicht des in Fig. 3 dargestellten beweglichen Teils,
- Fig. 7: eine Vorderansicht des in Fig. 3 dargestellten Stativteils und
- Fig. 8: eine rückseitige Ansicht des in Fig. 3 dargestellten Stativteils,
- Fig. 9: einen Querschnitt durch eine Haltevorrichtung in einer weiteren Ausführungsform,
- Fig. 10: einen weiteren Querschnitt durch die in Fig. 9 dargestellte Haltevorrichtung und
- Fig. 11: eine Draufsicht auf die in Fig. 9 dargestellte Haltevorrichtung.

Nachfolgend bezeichnen gleiche Bezugszeichen Elemente mit gleichen oder ähnlichen technischen Merkmalen.

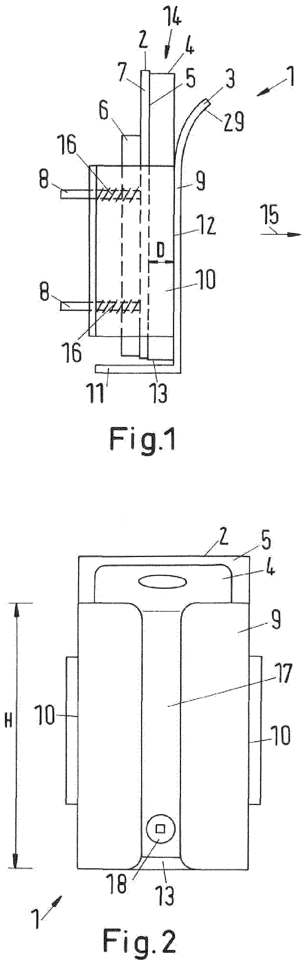

In Fig. 1 ist eine Seitenansicht einer Haltevorrichtung 1 in einer ersten Ausführungsform dargestellt. Die Haltevorrichtung 1 umfasst einen Stativteil 2 und einen beweglichen Teil 3. Die Haltevorrichtung 1 dient zur Halterung eines drahtlos koppelbaren Endgeräts 4. Der Stativteil 2 umfasst eine Rückwand 7, die eine ebene Auflagefläche 5 mit vorbestimmten Abmaßen aufweist. Die Auflagefläche 5 wird hierbei von einer Vorderseite der Rückwand 7 ausgebildet. Weiter umfasst die Haltevorrichtung 1 eine stativseitig angeordnete Leiterstruktur, die in einen Trägerblock 6 integriert ist, wobei der Trägerblock 6 an einer der Auflagefläche 5 entgegengesetzten Rückseite der Rückwand 7 des Stativteils 2 angeordnet ist. Somit ist die Leiterstruktur mit einem vorbestimmten Abstand von der Auflagefläche 5 angeordnet. Weiter dargestellt ist, dass der Stativteil 2 Führungszapfen 8 umfasst, die sich senkrecht von der Rückseite der Rückwand 7 weg erstrecken.

Der bewegliche Teil 3 umfasst eine Vorderwand 9, zwei Seitenwände 10 und eine Bodenwand 11. Der bewegliche Teil 3 ist derart beweglich an dem Stativteil 2 befestigt, dass eine von der Vorderwand 9 ausgebildete Andruckfläche 12 parallel zur Auflagefläche 5 verläuft. Die Seitenwände 10 und die Bodenwand 11 sind hierbei jeweils senkrecht zur Vorderwand 9 bzw. zur Andruckfläche 12 an dem beweglichen Teil 3 angeordnet. Der bewegliche Teil 3, insbesondere die Vorderwand 9, die Seitenwände 10 und die Bodenwand 11 sowie der Stativteil 2, insbesondere die Rückwand 7 des Stativteils 2, schließen hierbei ein Aufnahmevolumen 13 ein, welches zu einer der Bodenwand 11 gegenüberliegenden Stirnseite 14 hin offen ist. Somit kann das Endgerät 4 von der Stirnseite 14 her in das Aufnahmevolumen 13 eingebracht werden. Ein Abstand D der Andruckfläche 12 von der Auflagefläche 5 in vertikaler Richtung, die durch einen Pfeil 15 symbolisiert ist, ist einstellbar. Hierzu kann der bewegliche Teil 3 mit einer Linearbewegung, die in oder entgegen der vertikalen Richtung 15 orientiert ist, auf die Auflagefläche 5 zu oder von der Auflagefläche 5 wegbewegt werden. Zur Führung dieser Linearbewegung weist der bewegliche Teil 3 nicht dargestellte Führungslöcher auf, durch die sich die Führungszapfen 8 des Stativteils 2 erstrecken. Die Führungszapfen 8 und die Führungslöcher dienen somit als Führungselemente der Linearbewegung.

Weiter ist dargestellt, dass Spiralfedern 16 zwischen dem Stativteil 2 und dem beweglichen Teil 3 angeordnet sind. Insbesondere sind die Spiralfedern um die Führungszapfen 8 herum angeordnet und mit einem Ende an der Rückwand 7 des Stativteils 2 und mit einem anderen Ende am beweglichen Teil 3 befestigt. Wird der bewegliche Teil 3 in der vertikalen Richtung 15 von der Auflagefläche 5 wegbewegt, so werden die Spiralfedern 16 zusammengepresst und erzeugen eine zum Verschiebeweg proportionale Kraft, die entgegen der vertikalen Richtung 15 auf das bewegliche Teil 3 wirkt. Die Spiralfedern 16 können vorgespannt sein, wobei auf das bewegliche Teil 3 auch dann eine Federkraft entgegen der vertikalen Richtung 15 ausgeübt wird, wenn die Andruckfläche 12 des beweglichen Teils 3 auf der Auflagefläche 5 des Stativteils 2 aufliegt. Ein Benutzer muss dann den beweglichen Teil 3 entgegen dieser Federkraft von der Auflagefläche 5 wegbewegen, um ein Aufnahmevolumen 13 entsprechend einer Größe des einzulegenden Endgeräts 4 einzustellen. Dann kann das Endgerät 4 in das Aufnahmevolumen 13 eingebracht werden. Wird dann die vom Benutzer auf das bewegliche Teil 3 ausgeübte Betätigungskraft reduziert oder das bewegliche Teil 3 losgelassen, so wird die Andruckfläche 12 des beweglichen Teils 3 aufgrund der von den Spiralfedern 16 erzeugten Kraft entgegen der vertikalen Richtung 15 auf die Auflagefläche 5 zubewegt, wodurch das Endgerät 4 zwischen der Auflagefläche 5 und der Andruckfläche 9 eingeklemmt wird. Auch in diesem Zustand wirkt weiter eine von Null verschiedene Federkraft entgegen der vertikalen Richtung 15 auf das Endgerät 4, die von den Spiralfedern 16 erzeugt wird.

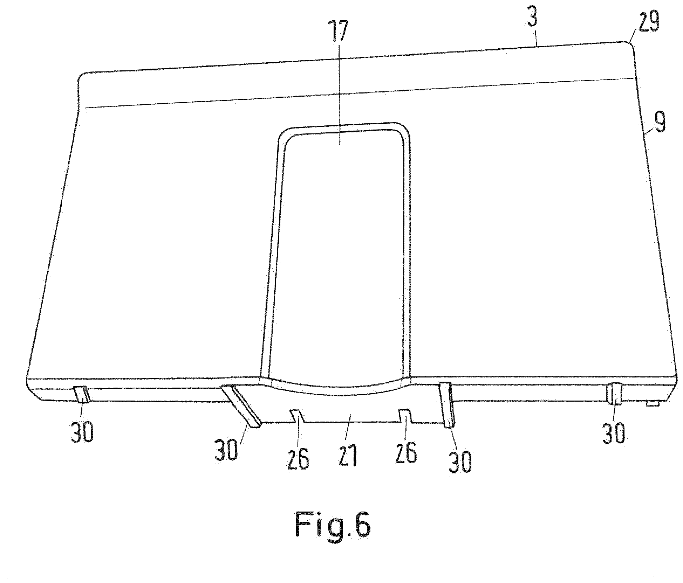

Weiter ist dargestellt, dass die Vorderwand 9 an einem der Bodenwand 11 gegenüberliegenden Ende eine nach außen gebogene Kante 29 aufweist. Dies wird in Bezug auf Fig. 6 näher erläutert.

In Fig. 2 ist eine Vorderansicht der in Fig. 1 dargestellten Haltevorrichtung 1 dargestellt. Hierbei ist dargestellt, dass die Vorderwand 9 des beweglichen Teils 3 eine Aussparung 17 in Form eines Schlitzes aufweist, der sich über eine gesamte Höhe H der Vorderwand 9 erstreckt. Hierdurch kann das Endgerät 4 auch im gehalterten Zustand durch einen Benutzer von außen betätigt werden, beispielsweise kann ein Bedienelement 18 des Endgeräts 4 auch im gehalterten Zustand z.B. durch einen Finger des Benutzers betätigt werden. Ebenfalls vorteilhaft ergibt sich, dass z.B. ein nicht dargestelltes Mikrofon des Endgeräts 4 nicht durch die Vorderwand 9 abgedeckt ist, wodurch auch im gehalterten Zustand ein Empfang von Sprache durch das Endgerät 4 nicht beeinträchtigt wird.

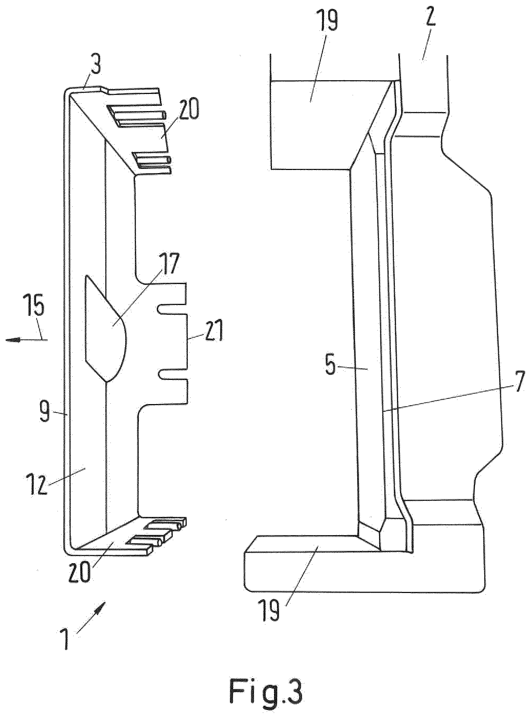

In Fig. 3 ist ein Stativteil 2 und ein beweglicher Teil 3 einer Haltevorrichtung 1 in einer weiteren Ausführungsform dargestellt. Der Stativteil 2 weist eine Auflagefläche 5 auf. Die Auflagefläche 5 wird hierbei von einer Vorderseite einer Rückwand 7 des Stativteils 2 ausgebildet. Weiter weist der Stativteil 2 Seitenwände 19 auf, die senkrecht zur Rückwand 7 verlaufen und an dem Stativteil 2 angeordnet sind. In dem von den Seitenwänden 19 und der Rückwand 7 umfassten Volumen kann der bewegliche Teil 3 angeordnet werden. Der bewegliche Teil 3 weist eine Vorderwand 9 auf, die eine Andruckfläche 12 aufweist. Weiter weist der bewegliche Teil 3 Seitenteile 20 und einen Bodenteil 21 auf. Diese werden nachfolgend näher beschrieben. Dargestellt ist weiter, dass die Vorderwand 9 eine Aussparung 17 aufweist, wobei sich die Aussparung 17 nur über einen Teil einer Höhe der Vorderwand 9 erstreckt.

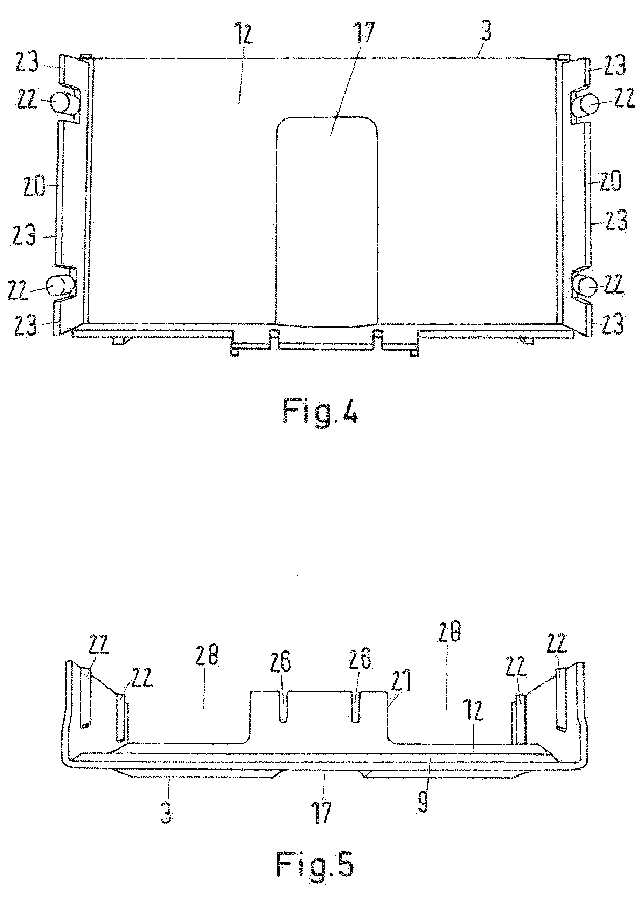

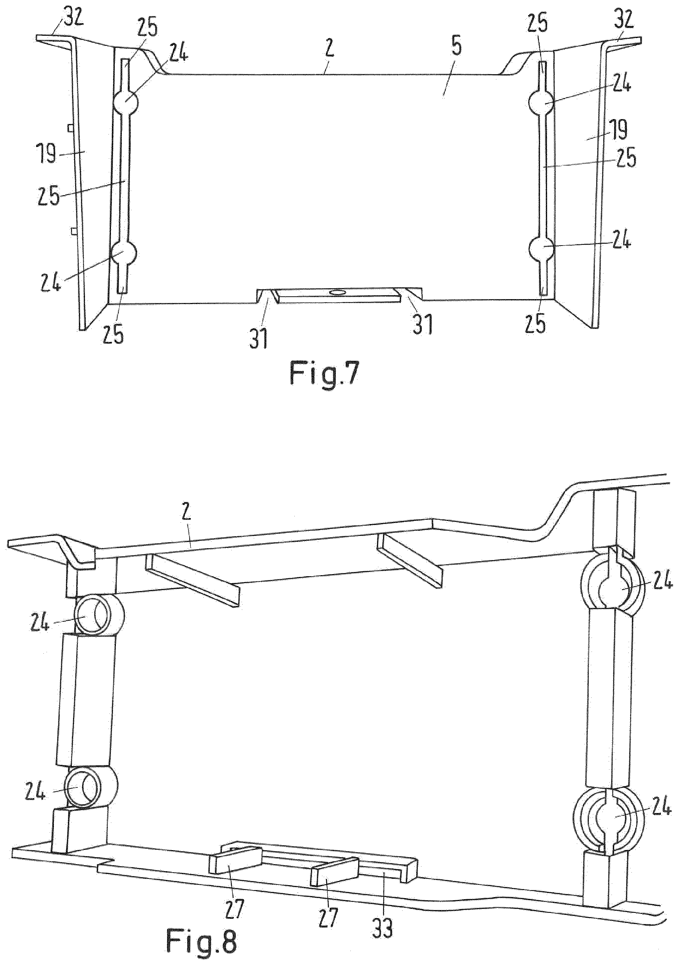

In Fig. 4 ist eine Vorderansicht des in Fig. 3 dargestellten beweglichen Teils 3 dargestellt. Die Seitenteile 20 weisen hierbei Führungszapfen 22 und Führungszungen 23 auf. Wird das bewegliche Teil 3 an dem in Fig. 3 dargestellten Stativteil 2 befestigt, erstrecken sich die Führungszapfen 22 durch korrespondierende Führungslöcher 24 und die Führungszapfen 23 durch entsprechende Führungsschlitze 25 (siehe Fig. 7). Durch die Führungszapfen 22, die Führungszungen 23, die Führungslöcher 24 und die Führungsschlitze 25 wird eine Linearbewegung des beweglichen Teils 3 relativ zum Stativteil 2 in und entgegen der in Fig. 3 mit einem Pfeil 15 dargestellten vertikalen Richtung mit einer Linearbewegung geführt.

In Fig. 5 ist eine Draufsicht auf das in Fig. 3 dargestellte bewegliche Teil 3 dargestellt. Hierbei ist ersichtlich, dass der Bodenteil 21 des beweglichen Teils 3 Führungsschlitze 26 aufweist. In diese Führungsschlitze 26 können Führungsstege 27 des Stativteils 2 (siehe Fig. 8) eingeführt werden, wenn der bewegliche Teil 3 am Stativteil 2 befestigt ist. Auch dies dient der Führung der vorhergehend erläuterten Linearbewegung des beweglichen Teils 3 relativ zum Stativteil 2. Hierbei ist dargestellt, dass auch der Bodenteil 21 des beweglichen Teils 3 Aussparungen 28 aufweist. Hierdurch kann ein in ein Aufnahmevolumen 13 (siehe Fig. 1) eingelegtes Endgerät 4 von einer Unterseite her gegriffen werden. So kann beispielsweise das in das Aufnahmevolumen 13 eingelegte Endgerät 4 zum Herausnehmen von der Unterseite her aus dem Aufnahmevolumen heraus geschoben werden. Hierdurch wird eine Entnahme des Endgeräts 4 aus dem Aufnahmevolumen 13 erleichtert.

In Fig. 6 ist eine perspektivische Ansicht des beweglichen Teils 3, welches in Fig. 3 dargestellt ist, dargestellt. Hierbei ist dargestellt, dass die Vorderwand 9 an einem dem Bodenteil 21 gegenüberliegenden Ende eine nach außen gebogene Kante 29 aufweist. Nach außen bedeutet hierbei, dass, wenn das bewegliche Teil 3 an dem Stativteil 2 befestigt ist, die Kante 29 in der vertikalen Richtung 15 von der Auflagefläche 5 weggebogen ist. Diese Kante 29 dient einer vereinfachten Betätigung, beispielsweise einem vereinfachten Greifen, des beweglichen Teils 3 durch einen Benutzer. Z.B. kann ein Finger des Benutzers von außen hinter die Kante 29 greifen, wodurch der Benutzer eine Betätigungskraft auf das bewegliche Teil 3 derart ausüben kann, dass das bewegliche Teil 3 in der vertikalen Richtung 15 von der Auflagefläche 5 wegbewegt wird, um ein Endgerät 4 (siehe Fig. 1) einzulegen. Weiter ist in Fig. 6 dargestellt, dass auch der Bodenteil 21 Führungsstege 30 aufweist, die in entsprechende Führungsschlitze 31 (siehe Fig. 7) des Stativteils 2 eingreifen, um die vorhergehend erläuterte Linearbewegung des beweglichen Teils 3 relativ zum Stativteil 2 zu führen. Weiter weist das Bodenteil 21 Führungsschlitze 26 auf, in welche Führungsstege 27 (siehe z.B. Fig. 8) eingreifen können.

In Fig. 7 ist eine Vorderansicht des Stativteils 2 dargestellt. Hierbei ist insbesondere die Auflagefläche 5 und die vorhergehend erläuterten Führungslöcher 24, Führungsschlitze 25 und Führungsschlitze 31 dargestellt. Der bewegliche Teil 3 kann hierbei zwischen den Seitenwänden 19 des Stativteils angeordnet werden, wodurch auch durch die Seitenwände 19 eine seitliche Bewegung des beweglichen Teils 3 begrenzt wird. An einer Oberseite weisen die Seitenwände 19 des Stativteils 2 nach außen hin abgewinkelte Kanten 32 auf. Diese können z.B. zum Befestigen, z.B. zum Auflegen, des Stativteils 2 auf einer Trägerstruktur, beispielsweise einer in einem Kraftfahrzeug angeordneten Trägerstruktur, dienen.

In Fig. 8 ist eine Rückansicht des in Fig. 3 dargestellten Stativteils 2 dargestellt. Neben den Führungslöchern 24 ist hierbei insbesondere eine rechteckförmige Öffnung 33 der Rückwand 7 des Stativteils 2 dargestellt, in die der vorstehende Teil des Bodenteils 21 des beweglichen Teils 3, der die Führungsschlitze 26 (siehe Fig. 6) ausbildet, eingeführt werden kann. Insbesondere sind hierbei auch die Führungsstege 27 dargestellt, die in die Führungsschlitze 26 eingreifen, um die Linearbewegung des beweglichen Teils 3 zu führen.

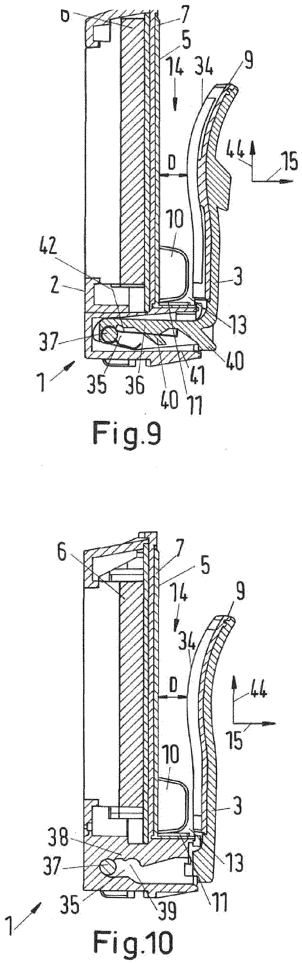

In Fig. 9 ist ein Querschnitt durch eine Haltevorrichtung 1 in einer weiteren Ausführungsform dargestellt. Die Haltevorrichtung 1 umfasst einen Stativteil 2 und einen beweglichen Teil 3.

Es ist dargestellt, dass der Stativteil 2 mehrteilig ausgebildet ist. Selbstverständlich kann der Stativteil 2 aber auch einteilig ausgebildet sein. Dargestellt ist weiter eine Rückwand 7 des Stativteils 2, die eine ebene Auflagefläche 5 mit vorbestimmten Abmaßen aufweist. Die Auflagefläche 5 wird hierbei von einer Vorderseite der Rückwand 7 ausgebildet.

Wie auch die in Fig. 1 dargestellte Haltevorrichtung 1, umfasst die in Fig. 9 dargestellte Haltevorrichtung 1 eine stativseitig angeordnete Leiterstruktur, die in einen Trägerblock 6 integriert ist, wobei der Trägerblock 6 an einer der Auflagefläche 5 entgegengesetzten Rückseite der Rückwand 7 des Stativteils 2 angeordnet ist. Somit ist die Leiterstruktur mit einem vorbestimmten Abstand von der Auflagefläche 5 angeordnet.

Im Unterschied zu der in Fig. 1 dargestellte Haltevorrichtung 1 weist der Stativteil 2 eine Seitenwand 10 und eine Bodenwand 11 auf.

Der bewegliche Teil 3 umfasst eine Vorderwand 9, wobei die Vorderwand 9 eine hin zur Auflagefläche 6 orientierte Oberfläche 34 ausbildet.

Die Seitenwände 10 und die Bodenwand 11 sind hierbei jeweils senkrecht zur Auflagefläche 5 angeordnet. Der bewegliche Teil 3, insbesondere die Vorderwand 9, die Seitenwände 10 und die Bodenwand 11 sowie der Stativteil 2, insbesondere die Rückwand 7 des Stativteils 2, schließen hierbei ein Aufnahmevolumen 13 ein, welches zu einer der Bodenwand 11 gegenüberliegenden Stirnseite 14 hin offen ist. Somit kann ein Endgerät 4 (siehe z.B. Fig. 1) von der Stirnseite 14 her in das Aufnahmevolumen 13 eingebracht werden. Ein vertikaler Abstand D der Oberfläche 34 von der Auflagefläche 5 in vertikaler Richtung, die durch einen Pfeil 15 symbolisiert ist, ist einstellbar.

Hierzu weist der Stativteil 2, insbesondere in einem Fußbereich, einen Führungsbereich 35 auf, wobei sich der Führungsbereich 35 in vertikaler Richtung 15 erstreckt. In dem Führungsbereich 35 ist ein Führungsabschnitt 36 des beweglichen Teils 3 anordenbar. Der Führungsabschnitt 36 wird hierbei von einem Schenkel des im wesentlichen L-förmigen beweglichen Teils 3 ausgebildet, wobei sich der Schenkel in vertikaler Richtung 15 erstreckt.

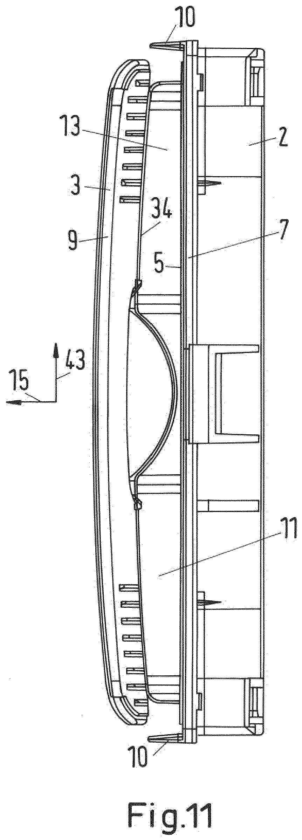

An einem freien Ende des Führungsabschnitts 36 weist der Führungsabschnitt 36 zwei Führungszapfen 37 auf, wobei jedoch nur ein Führungszapfen 37 dargestellt ist. Eine zentrale Symmetrieachse der Führungszapfen 37 ist parallel zur Auflagefläche 5 und parallel zu einer lateralen Richtung 43 (siehe Fig. 11) orientiert. Die laterale Richtung 43 ist senkrecht zur vertikalen Richtung 15 und senkrecht zu einer longitudinalen Richtung 44 orientiert. Die longitudinale Richtung 44 ist hierbei von der Bodenwand 11 hin zur geöffneten Stirnseite 14 des Aufnahmevolumens 13 orientiert. Die von der lateralen und longitudinalen Richtung 43, 44 aufgespannte Ebene ist parallel zur Auflagefläche 5. Bezeichnung wie "oben", "unten" beziehen sich hierbei auf die longitudinale Richtung 44.

Die beiden Führungszapfen 37 stehen hierbei in entgegengesetzter Richtung in oder entgegen der lateralen Richtung 43 von dem freien Ende des Führungsabschnitts 36 ab.

Weiter dargestellt ist, dass der Führungsabschnitt 36 des beweglichen Teils 3 Anschlagstege 40 aufweist, die sich zumindest teilweise hin zu einer Bodenseite 41 des Führungsbereichs 35 von dem Führungsabschnitt 36 weg erstrecken. Diese Anschlagstege 40 bilden Anschlagelemente aus, die eine nachfolgend erläuterte Drehbewegung des beweglichen Teils 3 begrenzen.

Weiter dargestellt ist eine Schenkelfeder 42, die ebenfalls in dem Führungsbereich 35 angeordnet ist. Die Schenkelfeder 42 weist ein V-förmiges Profil mit zwei Schenkeln und einem Federkopf auf, wobei der Federkopf abgerundet ausgebildet ist. Die Schenkelfeder 42 kann z.B. aus Bandstahl ausgeführt sein. Ein Radius des Federkopfs kann hierbei gleich dem oder um ein vorbestimmtes Maß größer als ein Radius des Führungszapfens 37 sein. Die Schenkelfeder 42 ist hierbei zwischen dem Führungsabschnitt 36 und der Bodenseite 41 des Führungsbereichs 35 angeordnet. Hierbei liegt ein Schenkel der Schenkelfeder 42 an einer Unterseite des Führungsabschnitts 36 und ein weiterer Schenkel der Schenkelfeder 42 an der Bodenseite 41 an. Bei einer Drehbewegung des beweglichen Teils um die Rotationsachse, insbesondere im mathematisch negativen Sinne, werden die Schenkel aufeinander zubewegt, wodurch die Schenkelfeder 42 gespannt wird und eine entsprechende Gegenkraft erzeugt. Wird in einem derart verdrehten Zustand keine äußere Kraft, z.B. durch einen Nutzer, auf das bewegliche Teil 3 ausgeübt, so führt das bewegliche Teil 3 aufgrund der Gegenkraft eine Drehbewegung in eine entgegengesetzt orientierte Drehrichtung, insbesondere im mathematisch positiven Sinne, aus, insbesondere bis eine Oberseite des Führungsabschnitts 36 an eine Deckenwand des Führungsbereichs 35 anschlägt. Die Deckenwand, die der Bodenseite 41 gegenüberliegend angeordnet ist, bildet somit auch ein Anschlagelement aus. In diesem Zustand kann die Schenkelfeder 42 vorgespannt sein.

In Fig. 10 ist ein weiterer Querschnitt durch die in Fig. 9 dargestellte Haltevorrichtung 1 dargestellt. Dargestellt ist, dass der Führungsbereich 35 zwischen Seitenwänden 38 des Stativteils 2 angeordnet ist. Hierbei ist jedoch nur eine Seitenwand 38 dargestellt. Die Seitenwände 38 weisen jeweils ein Langloch 39 auf, welches sich in vertikaler Richtung 15 erstreckt. Die Führungszapfen 37 des beweglichen Teils 3 sind hierbei jeweils in einem Langloch 39 angeordnet.

Eine Breite des Langlochs 39, insbesondere in einem stativseitigen Endabschnitt des Langlochs 39, ändert sich entlang der vertikalen Richtung 15. So ist dargestellt, dass eine Längsseite, in diesem Fall eine obere Längsseite, des Langlochs 39 einen wellenförmigen Verlauf aufweist. Dieser wird ausgebildet, indem ein Profil der Längsseite im Querschnitt aus mehreren, insbesondere 3, aufeinanderfolgenden Kreisbogensegmenten besteht. Ein Radius der Kreisbogensegmente ist hierbei gleich oder um ein vorbestimmtes Maß kleiner oder größer als ein Radius eines Führungszapfens 37.

Die Führungszapfen 37 sind in dem entsprechenden Langloch 39 jeweils in und entgegen der vertikalen Richtung 15 bewegbar, wobei eine Rastposition des Führungszapfens 37 gegeben ist, wenn dieser in einem Volumenabschnitt des Langlochs 39 angeordnet ist, der zu einem Volumen korrespondiert, welches durch eines der Kreisbogensegmente begrenzt wird.

Aus einer solchen Rastposition heraus ist der Führungszapfen 37 nur dann bewegbar, falls eine Kraft auf das bewegliche Teil 3 ausgeübt wird, die ausreicht, um den Führungszapfen 37 durch die zwischen Mittelpunkten zweier benachbarter Kreisbogensegmente ausgebildete Verjüngung zu bewegen.

Durch die Führungszapfen 37, die in den Langlöchern 39 angeordnet sind, ist der bewegliche Teil 3 auch um eine Rotationsachse drehbar gelagert, wobei die Rotationsachse der vorhergehend erläuterten zentralen Symmetrieachse der Führungszapfen 37 entspricht. Somit kann der bewegliche Teil 3 eine Dreh- oder Kippbewegung ausführen. Die Rotationsachse kann beispielsweise in parallel zur einer Rollachse des Fahrzeugs orientiert sein. Auch kann die Rotationsachse derart orientiert sein, dass eine Winkeldifferenz zwischen der Rotationsachse und der Rollachse des Fahrzeugs kleiner als ein vorbestimmter Winkel, beispielsweise kleiner als 50°, 30° oder 15° ist.

Während einer Drehbewegung des beweglichen Teils verändert sich der Abstand D zwischen einem Andruckelement des beweglichen Teils 3, welches insbesondere von einem Punkt, einer Linie oder einer Teilfläche und der Oberfläche 34 ausgebildet wird, und der Auflagefläche 5.

Weiter ist in Fig. 9 und Fig. 10 dargestellt, dass Abschnitte der Oberfläche 34 der Vorderwand 9 mit einer ersten Krümmung gekrümmt ausgebildet sind. Ein erster Krümmungsradius dieser Abschnitte ist hierbei um eine Krümmungsachse festgelegt, die parallel zu der lateralen Richtung 43 orientiert ist.

In Fig. 11 ist eine Draufsicht auf die in Fig. 9 dargestellte Haltevorrichtung 1 dargestellt. Hierbei ist insbesondere auch dargestellt, dass mindestens ein Abschnitt der Oberfläche 34 der Vorderwand 9 des beweglichen Teils 3 mit einer weiteren Krümmung gekrümmt ausgebildet ist. Ein weiterer Krümmungsradius dieses mindestens einen Abschnitts ist hierbei um eine Krümmungsachse festgelegt, die parallel zur longitudinalen Richtung 44 orientiert ist. Hierbei ist dargestellt, dass die Oberfläche 34 die weitere Krümmung über eine gesamte Breite der Oberfläche 34 aufweist, wobei die Breite entlang der lateralen Richtung 43 erfasst wird.

Der bewegliche Teil 3 wird somit nur in zwei Punkten oder entlang zweier Linien auf der Oberfläche 34 mit einem eingelegten Endgerät 4 in mechanischem Kontakt stehen, insbesondere mit einem Rand des Endgeräts 4, wodurch ein mechanischer Kontakt zwischen dem beweglichen Teil 3 und z.B. einem Display des Endgeräts 4 vermieden werden kann.

In den Fig. 9, 10 und 11 ist nicht dargestellt, dass die Auflagefläche 5 gerippt ausgebildet und gummiert ist. Auch ist nicht dargestellt, dass die Oberfläche 34 gerippt ausgebildet und gummiert ist.

## Patentansprüche

1. Haltevorrichtung für ein drahtlos koppelbares Endgerät (4),
wobei die Haltevorrichtung (1) mindestens einen Stativteil (2) und mindestens einen beweglichen Teil (3) umfasst, wobei der Stativteil (2) mindestens eine Auflagefläche (5) für das Endgerät (4) aufweist,
wobei die Haltevorrichtung (1) mindestens eine stativseitig angeordnete Leiterstruktur umfasst,
wobei
der bewegliche Teil (3) mindestens ein Andruckelement aufweist, wobei der bewegliche Teil (3) derart beweglich an dem Stativteil (2) befestigt ist, dass ein variabler Abstand (D) zwischen der Auflagefläche (5) und dem Andruckelement einstellbar ist, wobei der bewegliche Teil (3) derart beweglich an dem Stativteil (2) befestigt ist, dass der bewegliche Teil (3) mit einer Translationsbewegung bewegbar ist,
**dadurch gekennzeichnet, dass**
die Leiterstruktur eine Leiterstruktur zur Erzeugung eines elektromagnetischen Wechselfelds für eine induktive Übertragung von Energie an das Endgerät (4) oder eine Antennenstruktur für eine uni- oder bidirektionale drahtlose Kommunikation mit dem Endgerät (4) ist, wobei der bewegliche Teil (3) derart beweglich an dem Stativteil (2) befestigt ist, dass der bewegliche Teil (3) mit einer Drehbewegung bewegbar ist, wobei der bewegliche Teil (3) mindestens einen Zapfen (37) aufweist, der drehbar am Stativteil (2) gelagert ist, wobei der mindestens eine Zapfen (37) in einem Langloch (39) oder einer Nut des Stativteils (2) angeordnet ist.

2. Haltevorrichtung nach Anspruch 1, **dadurch gekennzeichnet, dass** die Leiterstruktur mit einem vorbestimmten Abstand von der Auflagefläche (5) und/oder einer vorbestimmten Orientierung zur Auflagefläche (5) angeordnet ist.

3. Haltevorrichtung nach Anspruch 1 oder 2, **dadurch gekennzeichnet, dass** der bewegliche Teil (3) derart beweglich an dem Stativteil (2) befestigt ist, dass eine Rotationsachse der Drehbewegung mit der Translationsbewegung bewegbar ist.

4. Haltevorrichtung nach einem der Ansprüche 1 bis 3, **dadurch gekennzeichnet, dass** die Haltevorrichtung (1) mindestens ein Mittel zur Krafterzeugung umfasst, wobei das Mittel zur Krafterzeugung derart ausgebildet und angeordnet ist, dass auf das bewegliche Teil (3) eine in Richtung der Auflagefläche (5) orientierte Kraft wirkt, wenn ein Abstand (D) zwischen der Auflagefläche (5) und dem Andruckelement größer als Null oder größer als ein vorbestimmter Abstand, der größer als Null ist, ist.

5. Haltevorrichtung nach Anspruch 4, **dadurch gekennzeichnet, dass** das Mittel zur Krafterzeugung als Federelement ausgebildet ist, wobei der Stativteil (2) und der bewegliche Teil (3) über das Federelement mechanisch verbunden sind.

6. Haltevorrichtung nach einem der Ansprüche 1 bis 5, **dadurch gekennzeichnet, dass** der bewegliche Teil (3) Führungsmittel und der Stativteil (2) korrespondierende Führungsgegenmittel aufweist, wobei durch die Führungsmittel und die korrespondierenden Führungsgegenmittel das bewegliche Teil (3) derart führbar ist, dass das mindestens eine Andruckelement mit einer Linearbewegung und/oder mit einer Drehbewegung hin zur Auflagefläche (5) oder weg von der Auflagefläche (5) bewegbar ist.

7. Haltevorrichtung nach einem der Ansprüche 1 bis 6, **dadurch gekennzeichnet, dass** der bewegliche Teil (3) und/oder der Stativteil (2) mindestens ein Anschlagelement aufweist, wobei durch das Anschlagelement eine Bewegung des beweglichen Teils (3) begrenzt wird.

8. Haltevorrichtung nach einem der Ansprüche 1 bis 7, **dadurch gekennzeichnet, dass** der bewegliche Teil (3) eine Vorderwand (9) aufweist, wobei die Vorderwand (9) eine Andruckfläche (12) aufweist, wobei die Andruckfläche (12) parallel zur Auflagefläche (5) orientiert ist.

9. Haltevorrichtung nach einem der Ansprüche 1 bis 8, **dadurch gekennzeichnet, dass** der bewegliche Teil (3) eine Vorderwand (9) aufweist, wobei die Vorderwand (9) eine vorbestimmte Anzahl von Andruckabschnitten aufweist oder ausbildet.

10. Haltevorrichtung nach einem der Ansprüche 1 bis 9, **dadurch gekennzeichnet, dass** zumindest ein Teil der Vorderwand (9) eine gekrümmt ausgebildete Oberfläche (34) aufweist.

11. Haltevorrichtung nach einem der Ansprüche 1 bis 10, **dadurch gekennzeichnet, dass** zumindest ein Teil der Auflagefläche (5) und/oder zumindest ein Teil der Vorderwand (9) gerippt oder gekörnt ausgebildet ist und/oder dass zumindest ein Teil der Auflagefläche (5) und/oder zumindest ein Teil der Vorderwand (9) gummiert ist.

12. Haltevorrichtung nach einem der Ansprüche 8 bis 11, **dadurch gekennzeichnet, dass** die Vorderwand (9) des beweglichen Teils (3) eine Aussparung (17) aufweist.

13. Haltevorrichtung nach einem der Ansprüche 1 bis 12, **dadurch gekennzeichnet, dass** die Haltevorrichtung (1) mindestens ein Polsterelement umfasst, wobei das Polsterelement am Stativteil (2) oder am beweglichen Teil (3) angeordnet ist.

14. Verfahren zur Herstellung einer Haltevorrichtung (1) für ein drahtlos koppelbares Endgerät (4), wobei
- mindestens ein Stativteil (2) und mindestens ein beweglicher Teil (3) bereitgestellt wird, wobei der Stativteil (2) mindestens eine Auflagefläche (5) für das Endgerät (4) aufweist,
- mindestens eine Leiterstruktur bereitgestellt wird,
- die mindestens eine Leiterstruktur stativseitig angeordnet wird,
wobei
- der bewegliche Teil (3) mit mindestens einem Andruckelement bereitgestellt wird und
- der bewegliche Teil (3) derart beweglich an dem Stativteil (2) befestigt wird, dass ein variabler Abstand (D) zwischen der Auflagefläche (5) und dem Andruckelement einstellbar ist, wobei der bewegliche Teil (3) derart beweglich an dem Stativteil (2) befestigt ist, dass der bewegliche Teil (3) mit einer Translationsbewegung bewegbar ist,
**dadurch gekennzeichnet, dass**
die Leiterstruktur eine Leiterstruktur zur Erzeugung eines elektromagnetischen Wechselfelds für eine induktive Übertragung von Energie an das Endgerät (4) oder eine Antennenstruktur für eine uni- oder bidirektionale drahtlose Kommunikation mit dem Endgerät (4) ist, wobei der bewegliche Teil (3) derart beweglich an dem Stativteil (2) befestigt ist, dass der bewegliche Teil (3) mit einer Drehbewegung bewegbar ist, wobei der bewegliche Teil (3) mindestens einen Zapfen (37) aufweist, der drehbar am Stativteil (2) gelagert ist, wobei der mindestens eine Zapfen (37) in einem Langloch (39) oder einer Nut des Stativteils (2) angeordnet ist.

## Claims

1. Retaining device for a terminal (4) which can be coupled in a wireless manner,
wherein the retaining device (1) comprises at least one stand part (2) and at least one movable part (3), wherein the stand part (2) has at least one bearing surface (5) for the terminal (4),
wherein the retaining device (1) comprises at least one conductor structure arranged on the stand side,
wherein
the movable part (3) has at least one pressing element, wherein the movable part (3) is movably attached to the stand part (2) in such a way that a variable distance (D) can be set between the bearing surface (5) and the pressing element, wherein the movable part (3) is movably attached to the stand part (2) in such a way that the movable part (3) is movable by a translational movement,
**characterized in that**
the conductor structure is a conductor structure for generating an alternating electromagnetic field for inductively transmitting energy to the terminal (4) or is an antenna structure for unidirectional or bidirectional wireless communication with the terminal (4), wherein the movable part (3) is movably attached to the stand part (2) in such a way that the movable part (3) is movable by a rotational movement, wherein the movable part (3) has at least one pin (37) which is rotatably mounted on the stand part (2), wherein the at least one pin (37) is arranged in an elongated hole (39) or a groove of the stand part (2).

2. Retaining device according to claim 1, **characterized in that** the conductor structure is arranged at a predefined distance from the bearing surface (5) and/or at a predefined orientation relative to the bearing surface (5).

3. Retaining device according to claim 1 or 2, **characterized in that** the movable part (3) is movably attached to the stand part (2) in such a way that an axis of rotation of the rotational movement is movable by the translational movement.

4. Retaining device according to one of claims 1 to 3, **characterized in that** the retaining device (1) comprises at least one force-generating means, wherein the force-generating means is configured and arranged in such a way that a force oriented in the direction of the bearing surface (5) acts on the movable part (3) when a distance (D) between the bearing surface (5) and the pressing element is greater than zero or is greater than a predefined distance that is greater than zero.

5. Retaining device according to claim 4, **characterized in that** the force-generating means is configured as a spring element, wherein the stand part (2) and the movable part (3) are mechanically connected via the spring element.

6. Retaining device according to one of claims 1 to 5, **characterized in that** the movable part (3) has guide means and the stand part (2) has a corresponding mating guide means, wherein the movable part (3) can be guided by the guide means and the corresponding mating guide means in such a way that the at least one pressing element is movable towards the bearing surface (5) or away from the bearing surface (5) by a linear movement and/or by a rotational movement.

7. Retaining device according to one of claims 1 to 6, **characterized in that** the movable part (3) and/or the stand part (2) has at least one stop element, wherein a movement of the movable part (3) is limited by the stop element.

8. Retaining device according to one of claims 1 to 7, **characterized in that** the movable part (3) has a front wall (9), wherein the front wall (9) has a pressing surface (12), wherein the pressing surface (12) is oriented parallel to the bearing surface (5).

9. Retaining device according to one of claims 1 to 8, **characterized in that** the movable part (3) has a front wall (9), wherein the front wall (9) has or forms a predefined number of pressing sections.

10. Retaining device according to one of claims 1 to 9, **characterized in that** at least a portion of the front wall (9) has a curved surface (34).

11. Retaining device according to one of claims 1 to 10, **characterized in that** at least a portion of the bearing surface (5) and/or at least a portion of the front wall (9) is ribbed or grained, and/or **in that** at least a portion of the bearing surface (5) and/or at least a portion of the front wall (9) is rubberized.

12. Retaining device according to one of claims 8 to 11, **characterized in that** the front wall (9) of the movable part (3) has a cutout (17).

13. Retaining device according to one of claims 1 to 12, **characterized in that** the retaining device (1) comprise at least one cushioning element, wherein the cushioning element is arranged on the stand part (2) or on the movable part (3).

14. Method for producing a retaining device (1) for a terminal (4) which can be coupled in a wireless manner, wherein
- at least one stand part (2) and at least one movable part (3) are provided, wherein the stand part (2) has at least one bearing surface (5) for the terminal (4),
- at least one conductor structure is provided,
- the at least one conductor structure is arranged on the stand side,
wherein
- the movable part (3) is provided with at least one pressing element, and
- the movable part (3) is movably attached to the stand part (2) in such a way that a variable distance (D) can be set between the bearing surface (5) and the pressing element, wherein the movable part (3) is movably attached to the stand part (2) in such a way that the movable part (3) is movable by a translational movement,
**characterized in that**
the conductor structure is a conductor structure for generating an alternating electromagnetic field for inductively transmitting energy to the terminal (4) or is an antenna structure for unidirectional or bidirectional wireless communication with the terminal (4), wherein the movable part (3) is movably attached to the stand part (2) in such a way that the movable part (3) is movable by a rotational movement, wherein the movable part (3) has at least one pin (37) which is rotatably mounted on the stand part (2), wherein the at least one pin (37) is arranged in an elongated hole (39) or a groove of the stand part (2).

## Revendications

1. Dispositif de maintien pour un terminal pouvant être couplé sans fil (4),
dans lequel le dispositif de maintien (1) comprend au moins une partie trépied (2) et au moins une partie mobile (3), dans lequel la partie trépied (2) présente au moins une surface d'appui (5) pour le terminal (4),
dans lequel le dispositif de maintien (1) comprend au moins une structure conductrice agencée côté trépied, dans lequel
la partie mobile (3) présente au moins un élément presseur, dans lequel la partie mobile (3) est fixée de manière mobile à la partie trépied (2) de sorte qu'une distance variable (D) est réglable entre la surface d'appui (5) et l'élément presseur, dans lequel la partie mobile (3) est fixée de manière mobile à la partie trépied (2) de sorte que la partie mobile (3) est déplaçable avec un mouvement de translation,
**caractérisé en ce que**
la structure conductrice est une structure conductrice pour la génération d'un champ électromagnétique alternatif pour une transmission inductive d'énergie au terminal (4) ou une structure d'antenne pour une communication sans fil unidirectionnelle ou bidirectionnelle avec le terminal (4), dans lequel la partie mobile (3) est fixée de manière mobile à la partie trépied (2) de sorte que la partie mobile (3) est déplaçable avec un mouvement de rotation, dans lequel la partie mobile (3) présente au moins un tenon (37), qui est logé en rotation au niveau de la partie trépied (2), dans lequel l'au moins un tenon (37) est agencé dans un trou oblong (39) ou une rainure de la partie trépied (2).

2. Dispositif de maintien selon la revendication 1, **caractérisé en ce que** la structure conductrice est agencée à une distance prédéterminée de la surface d'appui (5) et/ou avec une orientation prédéterminée par rapport à la surface d'appui (5).

3. Dispositif de maintien selon la revendication 1 ou 2, **caractérisé en ce que** la partie mobile (3) est fixée de manière mobile à la partie trépied (2) de sorte qu'un axe de rotation du mouvement de rotation est déplaçable avec le mouvement de translation.

4. Dispositif de maintien selon l'une quelconque des revendications 1 à 3, **caractérisé en ce que** le dispositif de maintien (1) comprend au moins un moyen de génération de force, dans lequel le moyen de génération de force est réalisé et agencé de sorte qu'une force orientée en direction de la surface d'appui (5) agit sur la partie mobile (3), lorsqu'une distance (D) entre la surface d'appui (5) et l'élément presseur est supérieure à zéro ou supérieure à une distance prédéterminée, qui est supérieure à zéro.

5. Dispositif de maintien selon la revendication 4, **caractérisé en ce que** le moyen de génération de force est réalisé en tant qu'élément ressort, dans lequel la partie trépied (2) et la partie mobile (3) sont reliées mécaniquement par le biais de l'élément ressort.

6. Dispositif de maintien selon l'une quelconque des revendications 1 à 5, **caractérisé en ce que** la partie mobile (3) présente des moyens de guidage et la partie trépied (2) présente des contre-moyens de guidage correspondants, dans lequel la partie mobile (3) peut être guidée par les moyens de guidage et les contre-moyens de guidage correspondants de sorte que l'au moins un élément presseur est déplaçable avec un mouvement linéaire et/ou avec un mouvement de rotation vers la surface d'appui (5) ou à l'opposé de la surface d'appui (5).

7. Dispositif de maintien selon l'une quelconque des revendications 1 à 6, **caractérisé en ce que** la partie mobile (3) et/ou la partie trépied (2) présente au moins un élément de butée, dans lequel un mouvement de la partie mobile (3) est limité par l'élément de butée.

8. Dispositif de maintien selon l'une quelconque des revendications 1 à 7, **caractérisé en ce que** la partie mobile (3) présente une paroi avant (9), dans lequel la paroi avant (9) présente une surface de pression (12), dans lequel la surface de pression (12) est orientée parallèlement à la surface d'appui (5).

9. Dispositif de maintien selon l'une quelconque des revendications 1 à 8, **caractérisé en ce que** la partie mobile (3) présente une paroi avant (9), dans lequel la paroi avant (9) présente ou forme un nombre prédéterminé de sections de pression.

10. Dispositif de maintien selon l'une quelconque des revendications 1 à 9, **caractérisé en ce qu'**au moins une partie de la paroi avant (9) présente une surface réalisée de manière incurvée (34).

11. Dispositif de maintien selon l'une quelconque des revendications 1 à 10, **caractérisé en ce qu'**au moins une partie de la surface d'appui (5) et/ou au moins une partie de la paroi avant (9) est réalisée de manière nervurée ou granulée et/ou qu'au moins une partie de la surface d'appui (5) et/ou au moins une partie de la paroi avant (9) est caoutchoutée.

12. Dispositif de maintien selon l'une quelconque des revendications 8 à 11, **caractérisé en ce que** la paroi avant (9) de la partie mobile (3) présente un évidement (17).

13. Dispositif de maintien selon l'une quelconque des revendications 1 à 12, **caractérisé en ce que** le dispositif de maintien (1) comprend au moins un élément de rembourrage, dans lequel l'élément de rembourrage est agencé au niveau de la partie trépied (2) ou au niveau de la partie mobile (3).

14. Procédé de réalisation d'un dispositif de maintien (1) pour un terminal pouvant être couplé sans fil (4), dans lequel
- au moins une partie trépied (2) et au moins une partie mobile (3) sont mises à disposition, dans lequel la partie trépied (2) présente au moins une surface d'appui (5) pour le terminal (4),
- au moins une structure conductrice est mise à disposition,
- l'au moins une structure conductrice est agencée côté trépied,
dans lequel
- la partie mobile (3) avec au moins un élément presseur est mise à disposition et
- la partie mobile (3) est fixée de manière mobile à la partie trépied (2) de sorte qu'une distance variable (D) est réglable entre la surface d'appui (5) et l'élément presseur, dans lequel la partie mobile (3) est fixée de manière mobile à la partie trépied (2) de sorte que la partie mobile (3) est déplaçable avec un mouvement de translation,
**caractérisé en ce que**
la structure conductrice est une structure conductrice pour la génération d'un champ électromagnétique alternatif pour une transmission inductive d'énergie au terminal (4) ou une structure d'antenne pour une communication sans fil unidirectionnelle ou bidirectionnelle avec le terminal (4), dans lequel la partie mobile (3) est fixée de manière mobile à la partie trépied (2) de sorte que la partie mobile (3) est déplaçable avec un mouvement de rotation, dans lequel la partie mobile (3) présente au moins un tenon (37), qui est logé en rotation au niveau de la partie trépied (2), dans lequel l'au moins un tenon (37) est agencé dans un trou oblong (39) ou une rainure de la partie trépied (2).
